# FASCICULE DE BREVET EUROPEEN

(11) **EP 2 870 631 B1**
(45) Date de publication et mention de la délivrance du brevet: **10.06.2020**
(21) Numéro de dépôt: 13734123.6
(22) Date de dépôt: 05.07.2013
(51) Int. Cl.: H01L 27/146

(54) **PROCÉDÉ DE RÉALISATION D'UN DISPOSITIF IMAGEUR CMOS À GÉOMÉTRIE OPTIMISÉE PAR PHOTOCOMPOSITION.**
VERFAHREN ZUR HERSTELLUNG EINER CMOS-BILDGEBUNGSVORRICHTUNG MIT OPTIMIERTER FORM MITTELS LICHTSATZ
METHOD FOR PRODUCING A CMOS IMAGING DEVICE HAVING OPTIMIZED SHAPE BY MEANS OF PHOTOCOMPOSITION

(30) Priorité: 05.07.2012 FR 1256469
(43) Date de publication de la demande: 13.05.2015
(73) Titulaire: Commissariat à l'Énergie Atomique et aux Énergies Alternatives, 75015 Paris (FR); Trixell, 38430 Moirans (FR)
(72) Inventeur: ROHR, Pierre, 38140 Apprieu (FR); MARTIN, Jean-Luc, 38620 Saint Geoire En Valdaine (FR); BOSSET, Bruno, 38500 Voiron (FR); DUPONT, Bertrand, 84400 Gargas (FR)
(74) Mandataire: Collet, Alain
(86) Numéro de dépôt international: PCT/EP2013/064320
(87) Numéro de publication internationale: WO 2014/006214

(56) Documents cités:
- EP-A1- 1 255 401
- EP-A2- 0 328 410
- WO-A1-2007/014293
- WO-A1-2009/133154
- FR-A1- 2 888 044
- US-A1- 2008 128 698
- US-A1- 2010 002 115
- US-A1- 2010 118 168

## Description

L'invention se situe dans le domaine des dispositifs imageurs numériques, notamment des dispositifs destinés à l'imagerie médicale par rayons X. Elle concerne un dispositif imageur , qui ne fait pas partie de l'invention, mais sert pour mieux comprendre l'invention, comprenant des pixels adressés individuellement par des circuits d'adressage. L'invention concerne un procédé de réalisation d'un tel dispositif imageur par photolithographie.

Un dispositif imageur numérique comprend en général un capteur d'images et des moyens de traitement. Les capteurs d'images actuels peuvent être réalisés à l'aide de différentes technologies basées souvent sur des substrats en silicium monocristallin, à savoir les capteurs à technologie CCD ("Charge-Coupled Device" ou dispositif à couplage/transfert de charge), les capteurs MOS ("Metal Oxide Semiconductor", semi-conducteur à oxyde de métal) et CMOS ("Complementary MOS"), mais également pour certaines applications plus spécifiques sur des technologies basées par exemple sur des couches minces en silicium amorphe (a-Si:H), voire d'autres matériaux ou substrats. Indépendamment de la technologie utilisée, dans chaque catégorie, le capteur d'images comprend des points photosensibles, également appelés pixels, organisés en lignes et en colonnes pour former une matrice. Chaque pixel est apte à convertir le rayonnement électromagnétique auquel il est exposé en charges électriques et comprend un élément collecteur de charges collectant des charges électriques sous l'effet d'un rayonnement photonique incident. Les charges électriques peuvent notamment être générées par des éléments photosensibles associés aux éléments collecteurs de charges. Traditionnellement les pixels comprennent un ou plusieurs éléments photosensibles permettant de détecter un rayonnement électromagnétique avec une longueur d'onde dans le domaine visible ou proche du domaine visible. Dans le domaine médical et dans le domaine industriel, où des rayonnements X ou γ peuvent être utilisés, il est d'usage d'interposer un convertisseur de rayonnement entre la source du rayonnement et le capteur d'images. Un tel convertisseur peut par exemple être un scintillateur ou un photoconducteur, convertissant respectivement le rayonnement électromagnétique incident dans un rayonnement de longueur d'onde plus grande, typiquement celui de la lumière visible, ou en charge électrique. Autrement dit, le scintillateur émet des photons sous l'effet d'un rayonnement incident tandis que le photoconducteur génère des porteurs de charge sous l'effet d'un rayonnement incident. Pour ces raisons la conversion par scintillateur est communément appelée conversion indirecte et la conversion par matériau photoconducteur, conversion directe (par référence au signal de sortie électrique).

Dans un capteur d'images à technologie CCD, les charges électriques sont lues en étant déplacées de pixel en pixel jusqu'à un circuit de lecture de charge placé à une extrémité de la matrice. Dans un capteur d'images réalisé à partir de filières technologiques MOS ou CMOS, les moyens de lecture des charges électriques sont en général partiellement intégrés aux pixels. Les charges électriques sont converties en signaux électriques à l'intérieur même des pixels. Ces signaux électriques sont lus ligne par ligne à chaque extrémité des colonnes de pixels. À cet effet, chaque pixel comporte au moins un élément ayant une fonction de commande ou de traitement (ex. interrupteur, reset, amplification) en plus du ou des élément(s) photosensible(s) ou de l'élément collecteur de charges. Dans les dispositifs autres que CCD, les pixels sont communément classés en 2 grandes catégories à savoir, d'une part, les pixels passifs dans lesquels les charges sont transférées à l'extérieur des pixels sans traitement supplémentaire et, d'autre part, les pixels actifs qui intègrent des fonctions de traitement un peu plus sophistiquées localement au niveau des pixels (ex. amplification). Le capteur d'images comporte également des conducteurs de ligne reliant les pixels ligne par ligne, et des conducteurs de colonne reliant les pixels colonne par colonne. Les conducteurs de ligne sont connectés à un circuit d'adressage, également appelé bloc d'adressage de lignes, et les conducteurs de colonne sont connectés à un circuit de lecture, également appelé bloc de lecture de colonnes. Les blocs d'adressage de lignes et les blocs de lecture de colonnes sont disposés à la périphérie de la matrice, sur deux côtés perpendiculaires. Le bloc d'adressage de lignes permet d'actionner les éléments interrupteurs des pixels ligne par ligne, et le bloc de lecture de colonnes permet de lire les signaux électriques sur les conducteurs de colonne. Les moyens de traitement du dispositif imageur permettent de traiter les signaux bruts récupérés sur le bloc de lecture de colonnes.

Dans le domaine de l'imagerie par rayons X, les capteurs d'images en technologie MOS ou CMOS sont connus mais peu utilisés à ce stade, à l'exception du domaine dentaire intra-oral, notamment en raison des dimensions limitées nécessaires à cette application. Cela résulte de la conjugaison de deux facteurs. Le premier facteur est que les rayonnements X ne peuvent pas être focalisés sur des distances compatibles avec les applications, c'est-à-dire typiquement de l'ordre du mètre. En conséquence, les dimensions du capteur d'images doivent être au moins égales à celles de l'objet à imager. Le deuxième facteur est que les capteurs d'images MOS et CMOS sont réalisés sur des plaquettes de silicium, appelées "wafers" dans la littérature anglo-saxonne, dont les dimensions sont relativement réduites. Ces plaquettes ont un diamètre compris la plupart du temps entre 100 millimètres (mm) et 300 mm. Un capteur d'images MOS ou CMOS de forme rectangulaire réalisé sur une plaquette de silicium présente donc des dimensions nettement inférieures à 300 mm. Ainsi, de nombreux organes du corps humain ne peuvent pas être imagés par un tel capteur. Des capteurs d'images utilisant des plaquettes de silicium de diamètre supérieur auraient un coût prohibitif. Une solution consiste à abouter plusieurs capteurs d'images CMOS les uns à côté des autres selon une ou deux directions, comme cela est pratiqué avec des matrices de détection en technologie silicium amorphe (a-Si:H). Cependant, pour les capteurs d'images, l'aboutement des pixels d'un premier capteur avec ceux d'un deuxième capteur est fortement pénalisé, voire empêché sur les côtés où se trouvent les blocs d'adressage de lignes et/ou de colonnes, en raison de la difficulté de capter un signal représentatif dans cette zone. En outre, le pilotage des différents capteurs les uns avec les autres est rendu complexe. Un autre inconvénient de la réalisation de capteurs d'images MOS ou CMOS à géométrie rectangulaire sur des plaquettes de silicium est que les zones de défauts sont en général plus denses en approchant du bord extérieur des plaquettes. Il est donc préférable de ménager une zone d'exclusion à la périphérie des plaquettes de silicium, ce qui réduit encore la surface exploitée.

Le document D1 (US 2010/0002115) décrit un photodétecteur utilisé pour réaliser une image radiologique dentaire. Le document D1 décrit la mise en œuvre d'un seul jeu de masques sur lequel sont représentés plusieurs masques, afin de former par photocomposition le motif global du photodétecteur.

Un but de l'invention est notamment de remédier à tout ou partie des inconvénients précités en fournissant des capteurs en technologie MOS, CMOS ou toute technologie assimilée ou considérée comme proche ou dérivée (ex. BiCMOS pour Bipolaire-CMOS), utilisant des concepts de fabrication dont la géométrie est optimisée par rapport à celle des plaquettes en silicium sur lesquelles ils sont réalisés. A cet effet, l'invention a pour objet un procédé de réalisation d'un dispositif imageur selon la revendication 1, ce dispositif comprenant un capteur monolithique de superficie supérieure ou égale à 10 cm², le capteur comprenant :
▪ une zone image réalisée sur un seul substrat et comportant un ensemble de pixels agencés selon des lignes et des colonnes, le nombre de pixels par colonne n'étant pas uniforme pour toutes les colonnes de pixels, chaque pixel comprenant un élément collecteur de charges collectant des charges électriques générées en fonction d'un rayonnement photonique reçu par le dispositif imageur,
▪ des conducteurs de ligne reliant les pixels ligne par ligne,
▪ des conducteurs de colonne reliant les pixels colonne par colonne,
▪ des blocs d'adressage de lignes reliés aux conducteurs de lignes et permettant d'adresser individuellement chaque ligne de pixels, et
▪ des blocs de lecture de colonnes reliés aux conducteurs de colonne et permettant de lire les charges électriques collectées par les pixels de la ligne sélectionnée par les blocs d'adressage de lignes, les blocs de lecture de colonnes étant situés à la périphérie de la zone image,
   les blocs d'adressage de lignes et les blocs de lecture de colonnes étant réalisés sur le même substrat que la zone image.

Selon une forme particulière de réalisation, au moins deux blocs de lecture de colonnes sont contigus à des pixels appartenant à des lignes de rangs distincts. Autrement dit, tous les blocs de lecture de colonnes ne sont pas alignés entre eux selon une unique ligne parallèle aux lignes de pixels.

Avantageusement, le nombre de pixels par colonne est adapté de manière à ce que les pixels périphériques de la zone image forment sensiblement un polygone comprenant au moins 5 côtés. La zone image présente ainsi une forme non rectangulaire. Le polygone comprend de préférence un nombre de côtés inférieur à 20 afin de faciliter la réalisation du capteur et sa découpe. Dans un mode de réalisation particulièrement avantageux, les pixels périphériques de la zone image forment sensiblement un octogone régulier. Pour une zone image de forme polygonale, les blocs de lecture de colonnes peuvent être regroupés par ensembles, chaque ensemble étant parallèle à l'un des côtés du polygone.

En particulier, les blocs de lecture de colonnes d'un premier ensemble peuvent être situés sur un premier côté de l'octogone régulier, les blocs de lecture de colonnes d'un deuxième ensemble peuvent être situés sur un deuxième côté adjacent au premier, et les blocs de lecture de colonnes d'un troisième ensemble peuvent être situés sur un troisième côté adjacent au deuxième côté.

Les blocs d'adressage de lignes peuvent être situés à la périphérie de la zone image. En particulier, ils peuvent être situés sur des côtés de l'octogone régulier opposés au premier, au deuxième et au troisième côté, les conducteurs de ligne étant formés sur une première face ou couche métallique du substrat, le capteur comprenant, en outre, des bus de commande formés sur une deuxième face ou couche métallique du substrat et des trous métallisés formés dans la zone image, les bus de commande étant orientés parallèlement aux colonnes de pixels et étant reliés aux blocs d'adressage de lignes, et les trous métallisés reliant chaque conducteur de ligne à l'un des bus de commande. Dans un autre mode de réalisation, les blocs d'adressage de lignes sont situés sur les mêmes cotés de l'octogone régulier que les blocs de lecture de colonnes, les conducteurs de ligne étant formés sur une première face ou couche métallique du substrat, le capteur comprenant, en outre, des bus de commande formés sur une deuxième face ou couche métallique du substrat et des trous métallisés formés dans la zone image, les bus de commande étant orientés parallèlement aux colonnes de pixels et étant reliés aux blocs d'adressage de lignes, les trous métallisés reliant chaque conducteur de ligne à l'un des bus de commande.

Selon une autre forme de réalisation, les blocs de lecture de colonnes sont situés sur une partie d'un premier côté de l'octogone régulier, sur un deuxième côté adjacent au premier côté, sur une partie d'un troisième côté, opposé au premier côté, et sur un quatrième côté, opposé au deuxième côté, les parties des premier et troisième côtés étant complémentaires afin de permettre la lecture de chacune des colonnes de pixels de la zone image, les blocs d'adressage de lignes étant situés sur une partie d'un cinquième côté, adjacent au deuxième côté, sur un sixième côté, adjacent aux troisième et cinquième côtés, sur une partie d'un septième côté, opposé au cinquième côté, et sur un huitième côté, opposé au sixième côté, les parties des cinquième et septième côtés étant complémentaires afin de permettre l'adressage de chacune des lignes de pixels de la zone image.

Les blocs d'adressage de lignes peuvent aussi être situés à l'intérieur de la zone image. En particulier, les blocs d'adressage de lignes peuvent être adjacents à l'une des colonnes de pixels comprenant le plus grand nombre de pixels.

Selon une autre forme de réalisation, les blocs d'adressage de lignes sont situés à la périphérie de la zone image, des blocs d'adressage de lignes étant parallèles aux lignes de pixels et des blocs d'adressage de lignes étant inclinés par rapport aux lignes et aux colonnes de pixels, les conducteurs de ligne étant formés sur une première face ou couche métallique du substrat, le capteur comprenant, en outre, des bus de commande formés sur une deuxième face ou couche métallique du substrat et des trous métallisés 62 formés dans la zone image, les bus de commande étant orientés parallèlement aux colonnes de pixels et étant reliés aux blocs d'adressage de lignes, les trous métallisés reliant chaque conducteur de ligne à l'un des bus de commande.

Selon une autre forme de réalisation, les blocs de lecture de colonnes et les blocs d'adressage de lignes sont situés à la périphérie de la zone image, parallèlement aux lignes de pixels, les conducteurs de ligne étant formés sur une première face ou couche métallique du substrat, le capteur comprenant, en outre, des bus de commande formés sur une deuxième face ou couche métallique du substrat et des trous métallisés formés dans la zone image, les bus de commande étant orientés parallèlement aux colonnes de pixels et étant reliés aux blocs d'adressage de lignes, les trous métallisés reliant chaque conducteur de ligne à l'un des bus de commande.

Selon une autre forme de réalisation, chaque bloc de lecture de colonnes est parallèle aux lignes de pixels, une partie des blocs de lecture de colonnes étant située à une première extrémité des colonnes de pixels et une autre partie étant située à une deuxième extrémité des colonnes de pixels, les deux parties étant complémentaires afin de permettre la lecture de chacune des colonnes de pixels de la zone image, les blocs d'adressage de lignes étant situés à la périphérie de la zone image, parallèlement aux colonnes de pixels, une partie des blocs d'adressage de lignes étant située à une première extrémité des lignes de pixels et une autre partie étant située à une deuxième extrémité des lignes de pixels, les deux parties étant complémentaires afin de permettre l'adressage de chacune des lignes de pixels de la zone image.

Les pixels périphériques de la zone image peuvent aussi former sensiblement un hexagone convexe dont un premier côté est parallèle aux lignes de pixels, dont un deuxième et un troisième côté, adjacents au premier côté, sont parallèles aux colonnes de pixels, dont un quatrième et un cinquième côté, respectivement adjacents au deuxième et au troisième côté, sont inclinés par rapport aux lignes et aux colonnes de pixels, et dont un sixième côté, adjacent au quatrième et au cinquième côté, est parallèle aux lignes de pixels.

Chaque pixel du capteur comporte par exemple un élément photosensible générant des charges électriques en fonction d'un rayonnement reçu par le dispositif imageur.

Un scintillateur peut être couplé optiquement au capteur afin de convertir un rayonnement X ou gamma en un rayonnement auquel les éléments photosensibles sont sensibles.

À la place d'un élément photosensible, chaque pixel peut comprendre une électrode de collecte de charges électriques formant au moins une partie de l'élément collecteur de charges. Un photoconducteur peut alors être couplé électriquement aux électrodes de collecte de charges des pixels du capteur, le photoconducteur permettant de convertir un rayonnement X ou gamma en charges électriques. Le photoconducteur est par exemple réalisé en tellurure de cadmium (CdTe), en un composé comprenant du tellurure, du cadmium et du zinc (CdₓTe_{y}Zn_{z}), en arséniure de gallium (AsGa), en iodure de mercure (Hgl₂), en oxyde de plomb (PbO), en iodure de plomb (Pbl₂), ou en Sélénium (Se).

Chaque bloc d'adressage de lignes et chaque bloc de lecture de colonnes peut comprendre des plots de connexion aptes à relier les conducteurs de ligne et les conducteurs de colonnes à des circuits externes, lesdits plots de connexion étant alignés dans chaque bloc sur une ou plusieurs rangées. Les plots de connexion de chaque bloc sont de préférence alignés avec les bords du substrat.

L'invention porte sur un procédé de réalisation par photolithographie d'un dispositif imageur sur une plaquette semi-conductrice formant un substrat ; le capteur comprenant :
- une zone image réalisée sur le substrat et comprenant un ensemble de pixels agencés selon des lignes et des colonnes, le nombre de pixels par colonne n'étant pas uniforme pour toutes les colonnes de pixels, chaque pixel comprenant un élément collecteur de charges collectant des charges électriques générées en fonction d'un rayonnement photonique reçu par le dispositif imageur,
- des conducteurs de ligne reliant les pixels ligne par ligne,
- des conducteurs de colonne reliant les pixels colonne par colonne,
- des blocs d'adressage de lignes reliés aux conducteurs de lignes et permettant d'adresser individuellement chaque ligne de pixels, et
- des blocs de lecture de colonnes reliés aux conducteurs de colonne et permettant de lire les charges électriques collectées par les pixels de la ligne sélectionnée par les blocs d'adressage de lignes, les blocs de lecture de colonnes étant situés à la périphérie de la zone image,
- les blocs d'adressage de lignes et les blocs de lecture de colonnes étant réalisés sur le même substrat que la zone image ;
le procédé étant caractérisé en ce qu'il comprend une étape dans laquelle une surface de la plaquette semi-conductrice est exposée zone par zone à un rayonnement au travers d'au moins deux jeux de masques ; l'au moins deux jeux de masques étant configuré pour pouvoir réaliser, par photolithographie, différents motifs sur la surface de la plaquette semi-conductrice ; la zone image étant obtenue par la réalisation successive de motifs, adjacents les uns aux autres, sur la surface de la plaquette semi-conductrice ; la zone image ainsi obtenue présentant une superficie supérieure ou égale à 10 cm² ;
le procédé étant également caractérisé en ce que le nombre de motifs mis en œuvre est strictement supérieur à 1 et inférieur à 15.

Avantageusement, le nombre de motifs mis en œuvre est inférieur à 8. Cela permet de limiter les opérations de photorépétitions mises en œuvre pour une partie du procédé de photolithographie nécessaire à la réalisation du dispositif imageur.

Avantageusement, le nombre de jeux de masques mis en œuvre est inférieur à 3. Le coût associé à chaque jeu de masques étant élevé, il convient de limiter le nombre de jeux de masques mis en œuvre.

Avantageusement, chaque masque d'un jeu de masque comporte n régions distinctes, permettant respectivement la réalisation, par photolithographie, de n motifs. n est un entier, de préférence compris entre 1 et 15 et de préférence compris entre 1 et 10.

La zone image peut être obtenue par la réalisation de motifs formés au moyen de deux ou trois jeux de masques. Ce nombre est à la fois suffisamment faible pour limiter le coût global d'industrialisation, et suffisamment important pour éviter de multiplier le nombre de zone de faible surface sur chacun des masques, et donc le nombre de photo-répétitions nécessaires pour la réalisation d'un capteur de grande dimension.

Ainsi, la plaquette étant divisée en zones élémentaires, le procédé consiste à constituer, par photolithographie, un motif sur chaque zone élémentaire, et cela zone par zone. Les motifs constitués sur des zones adjacentes sont interconnectés, de façon à constituer la zone image.

Autrement dit, on réalise la zone image par photocomposition, en combinant différentes opérations de photolithographie de façon à constituer différents motifs adjacents. La structure de ces motifs permet leur interconnexion.

Avantageusement, les pixels périphériques de la zone image forment sensiblement un polygone comprenant au moins 5 côtés.

Avantageusement, les pixels périphériques de la zone image forment sensiblement un polygone comprenant un nombre de côtés inférieur à 20.

Dans une mise en œuvre particulièrement avantageuse, les pixels périphériques de la zone image forment sensiblement un octogone régulier.

Chaque bloc d'adressage de lignes du capteur peut être formé par la réalisation d'un motif comprenant une région correspondant audit bloc d'adressage de lignes, au moins l'un des motifs formant un bloc d'adressage de lignes présentant des formes inclinées par rapport aux lignes et aux colonnes de pixels.

De même, chaque bloc de lecture de colonnes du capteur peut être formé par la réalisation d'un motif comprenant une région correspondant audit bloc, au moins l'un des motifs formant un bloc de lecture de colonnes présentant des formes inclinées par rapport aux lignes et aux colonnes de pixels.

Avantageusement, le ou les jeux de masques sont de forme rectangulaire ; chaque motif à réaliser sur la plaquette semi-conductrice étant sélectionné par un ou plusieurs volets d'obturation.

La surface de la plaquette semi-conductrice peut être exposée au travers d'un jeu de masques, dont chaque masque comporte une région permettant de former une ligne de découpe entourant la zone image, les blocs d'adressage de lignes et les blocs de lecture de colonnes ; la ligne de découpe facilitant la découpe de la plaquette semi-conductrice. Le procédé peut alors également comprendre en outre une étape de découpe de la plaquette semi-conductrice le long de la ligne de découpe pour former le capteur.

L'invention présente un intérêt particulier dans le domaine de l'imagerie par rayonnement ionisant où les objets présentent une forme sensiblement circulaire ou semi-circulaire, par exemple un cœur ou un sein. Elle présente alors l'avantage d'exploiter plus largement la surface de la plaquette de silicium sur laquelle est réalisé le capteur.

L'invention sera mieux comprise et d'autres avantages apparaîtront à la lecture de la description qui va suivre, faite en regard de dessins annexés sur lesquels :
- la figure 1 représente sous forme d'un schéma fonctionnel un exemple de capteur d'images CMOS sur lequel repose l'invention ;
- la figure 2 représente un premier exemple de réalisation d'un capteur selon l'invention ;
- les figures 3A et 3B représentent schématiquement un premier exemple de jeux de masques permettant de réaliser le capteur de la figure 2;
- la figure 4 représente un deuxième exemple de jeu de masques permettant de réaliser le capteur de la figure 2 ;
- les figures 5A et 5B représentent un troisième exemple de jeux de masques permettant de réaliser le capteur de la figure 2 ;
- la figure 6 représente un deuxième exemple de réalisation d'un capteur selon l'invention ;
- les figures 7A et 7B représentent un premier exemple de jeux de masques permettant de réaliser le capteur de la figure 6 ;
- les figures 8A et 8B représentent un deuxième exemple de jeux de masques permettant de réaliser le capteur de la figure 6 ;
- la figure 9 représente un troisième exemple de réalisation d'un capteur selon l'invention ;
- les figures 10A et 10B représente un exemple de jeux de masques permettant de réaliser le capteur de la figure 9 ;
- la figure 11 représente un quatrième exemple de réalisation d'un capteur selon l'invention ;
- les figures 12A, 12B et 12C représentent un exemple de jeux de masques permettant de réaliser le capteur de la figure 11 ;
- la figure 13 représente un cinquième exemple de réalisation d'un capteur selon l'invention ;
- les figures 14A et 14B représentent un exemple de jeux de masques permettant de réaliser le capteur de la figure 13 ;
- la figure 15 représente un sixième exemple de réalisation d'un capteur selon l'invention ;
- la figure 16 représente un exemple de jeu de masque permettant de réaliser le capteur de la figure 15.

De manière générale, l'invention concerne la réalisation d' un capteur intégré dans un dispositif imageur numérique et comportant un ensemble de pixels agencés selon des lignes et/ou des colonnes, des blocs d'adressage de lignes, des blocs de lecture de colonnes, des conducteurs de ligne reliant les lignes de pixels à un bloc d'adressage de lignes, et des conducteurs de colonne reliant les colonnes de pixels à un bloc de lecture de colonnes. Il est à noter que, dans le cadre de la présente demande de brevet, les notions de colonne et de ligne n'ont qu'un sens relatif, une ligne de pixels et une colonne de pixels n'étant autres que des rangées de pixels disposées typiquement perpendiculairement l'une à l'autre. Un conducteur de ligne, respectivement de colonne, est défini comme étant orienté parallèlement à une ligne de pixels, respectivement une colonne de pixels. L'ensemble des pixels d'un capteur forme une zone image. Chaque pixel comporte un élément collecteur de charges permettant de collecter des charges électriques induites à la réception de photons sur un convertisseur de rayonnement du dispositif imageur. La conversion de photons en charges électriques peut être soit assurée localement dans le pixel à l'aide d'un ou plusieurs éléments photosensibles (ex. photodiode, photoMOS...), soit déportée, par exemple une couche photoconductrice déposée directement sur le capteur ou couplée électriquement par une technique de connexion quelconque (ex. bump bonding...). Un convertisseur de rayonnement du style scintillateur peut être intégré ou non aux pixels du capteur. Lorsque le convertisseur de rayonnement est intégré, le capteur est qualifié de capteur d'images, et la zone image peut être appelée zone photosensible. Les éléments photosensibles d'un capteur d'images sont par exemple des photodiodes ou des phototransistors. Ils génèrent des charges électriques à la réception d'un rayonnement de photons, généralement dans le domaine visible. Dans le cas où le dispositif imageur est destiné à l'imagerie par rayonnement X ou γ, le dispositif imageur peut comporter un scintillateur associé au capteur d'images afin de convertir le rayonnement en un rayonnement auquel les éléments photosensibles sont sensibles. L'invention s'applique également à des capteurs ne comprenant pas d'éléments photosensibles. Dans de tels capteurs, le convertisseur de rayonnement peut consister en un photoconducteur disposé sur le capteur. Chaque pixel comprend par exemple une électrode de collecte de charges électriques et une capacité de stockage. Le photoconducteur est connecté nominalement à chaque électrode de collecte de charges des pixels du capteur, de sorte que les charges électriques issues de la conversion du rayonnement X ou *γ* sont collectées localement dans les pixels. Les blocs d'adressage de lignes permettent d'adresser individuellement chaque ligne de pixels par l'intermédiaire des conducteurs de ligne. Ils sont dimensionnés pour adresser chacun une ou de préférence plusieurs lignes de pixels. L'adressage d'une ligne de pixels consiste à commander un ou plusieurs actionneurs dans chacun des pixels de la ligne. Il comprend par exemple l'injection d'un signal dit de lecture sur un conducteur de ligne de manière à commander la lecture des charges électriques collectées dans les pixels de cette ligne. L'adressage d'une ligne de pixels peut aussi comprendre l'injection d'un signal dit de remise à zéro sur le même conducteur de ligne ou sur un autre conducteur de ligne de manière à commander la remise à zéro des pixels de cette ligne, c'est-à-dire le rétablissement d'une quantité de charges initiale. Les blocs de lecture de colonnes permettent en général de lire en parallèle sur les conducteurs de colonne les pixels de la ligne sélectionnée par les blocs d'adressage de lignes. Ils sont également dimensionnés pour lire chacun une ou de préférence plusieurs colonnes de pixels. La lecture d'un pixel situé à l'intersection d'une colonne et de la ligne sélectionnée par le bloc d'adressage de lignes comprend la réception sur le conducteur de colonne auquel il est relié d'un signal représentatif de la quantité de charges présentes dans ce pixel, elle même proportionnelle au niveau d'éclairement de ce pixel. À l'heure actuelle, les capteurs comprenant des pixels adressés à la fois par des blocs d'adressage de lignes et des blocs de lecture de colonnes sont réalisés notamment en technologie CMOS sur des substrats en silicium, en général sous forme de plaquettes circulaires.

Selon un premier aspect de l'invention, le capteur comprend un nombre non uniforme de pixels par colonne (la difficulté technique à surmonter étant liée au fait que les pixels sont "composés" par une technique de lithographie blocs). Autrement dit, toutes les colonnes de pixels ne comprennent pas nécessairement le même nombre de pixels. Par voie de conséquence, le nombre de pixels par ligne n'est pas non plus uniforme pour toutes les lignes. Le nombre de pixels par colonne et par ligne peut notamment être adapté de manière à ce qu'une partie des pixels périphériques du capteur forment sensiblement une courbe conique telle qu'un cercle ou un demi-cercle. Le nombre de pixels par colonne et par ligne peut aussi être adapté de manière à ce que la zone image du capteur forme un polygone autre qu'un quadrilatère. En particulier, la zone image peut former un polygone à plus de quatre côtés. De préférence, le polygone est convexe et régulier. Il comporte de préférence un nombre de côtés inférieur à 20, de manière à faciliter la découpe du capteur, selon une ligne de coupe disposée sur le substrat. Il s'agit par exemple d'un octogone, lequel présente un bon compromis entre le nombre de côtés et le facteur de remplissage sur une surface circulaire. L'octogone présente en outre l'avantage de comporter uniquement des côtés parallèles aux lignes de pixels, des côtés parallèles aux colonnes de pixels, et des côtés inclinés à 45° par rapport aux lignes et aux colonnes de pixels. Ce dernier aspect facilite le processus de fabrication du capteur par photocomposition. Les pixels ont généralement une forme carrée ou au moins rectangulaire, et des dimensions identiques. Ainsi, la forme du capteur peut être déterminée au pixel près, c'est-à-dire en disposant les pixels de manière à obtenir le contour le plus proche de la forme voulue. Certains pixels à la périphérie peuvent aussi avoir une forme différente afin d'approcher plus fidèlement la forme de capteur désirée. La forme du capteur peut aussi être approchée à plusieurs lignes ou colonnes de pixels près. Autrement dit, plusieurs lignes contiguës de pixels et plusieurs colonnes contiguës de pixels peuvent comporter un même nombre de pixels de manière à approcher globalement la forme de capteur souhaitée. En particulier, le nombre de lignes et de colonnes de pixels comportant un même nombre de pixels peut être adapté à la dimension des blocs d'adressage de lignes et à celle des blocs de lecture de colonnes. Cependant, il est préférable de réaliser un capteur dont la forme approche le plus précisément possible la forme désirée. En effet, la présence de créneaux implique des discontinuités importantes dans la longueur des conducteurs de ligne et de colonne, et donc la présence d'artefacts dans les images. Cela se traduit par une discontinuité dans l'image de noir, c'est-à-dire l'image obtenue en l'absence de faisceau incident, ce qui est préjudiciable à l'homogénéité spatiale du bruit.

Selon un deuxième aspect de l'invention, le capteur présente une grande surface, en l'occurrence au moins supérieure ou égale à 10 cm2, mais de préférence supérieure ou égale à 100 cm2, voire supérieure ou égale à 200 cm2. Les jeux de masques ou réticules utilisés dans les procédés de photolithographie actuels ayant des dimensions largement inférieures, de l'ordre de quelques centimètres de côté, le capteur est ainsi formé sur une plaquette semi-conductrice par un procédé de photolithographie composée, également appelé photocomposition ou "stitching" dans la littérature anglo-saxonne. Autrement dit, le capteur est formé par plusieurs expositions d'une plaquette semi-conductrice au travers d'un ou plusieurs masques (chacune des expositions comprenant une multitude d'éléments du capteur, par exemple plusieurs dizaines, centaines, voire milliers de pixels dans le cas de photocomposition de la zone matricielle). Ce deuxième aspect peut aussi être exprimé par le fait que le capteur selon l'invention présente au moins un bus métallique, par exemple un conducteur de ligne ou de colonne, dont la longueur est supérieure ou égale à 50 mm, c'est-à-dire supérieure à la plus grande dimension des masques utilisés actuellement dans les procédés de photolithographie.

La combinaison des premier et deuxième aspects de l'invention permet de réaliser des capteurs CMOS avec une grande surface et présentant un rapport surface sur coût très attractif. En particulier, le remplacement d'un tube intensificateur d'image radiologique de 9 pouces de diamètre (environ 230 mm) par un capteur CMOS de forme carrée dans lequel peut s'inscrire un cercle de cette dimension nécessite l'aboutage de plusieurs circuits réalisés chacun dans une plaquette silicium de 200 ou 300 mm de diamètre. En revanche, une forme contenant un cercle de 230 mm de diamètre est parfaitement réalisable dans une seule plaquette de même dimension. Ainsi, l'invention propose notamment de réaliser des capteurs CMOS dont la forme approche celle d'un cercle à partir d'une seule plaquette semi-conductrice.

Selon un troisième aspect de l'invention, les blocs d'adressage de lignes et les blocs de lecture de colonnes sont réalisés sur un même substrat que les pixels. En effet, il est nécessaire que les pixels, les blocs d'adressage et les blocs de lecture soient réalisés sur le même substrat, de façon à éviter les difficultés technologiques de raccordement lorsqu'on dispose de deux substrats, l'un portant les pixels, l'autre portant les blocs de lecture et/ou d'adressage.

Selon une forme particulière de réalisation de l'invention, le dispositif comporte des plots de connexion, réalisés sur le substrat, destinés à un raccordement à des circuits externes, ces derniers étant par exemple dédiés à l'alimentation, la synchronisation ou le traitement des signaux collectés. La connexion du capteur avec des circuits externes, par exemple des moyens de traitement, peut ainsi être réalisée facilement. Les plots de connexion peuvent être réalisés dans les blocs d'adressage de lignes et les blocs de lecture de colonnes. Les blocs sont alors de préférence disposés à la périphérie du substrat. Avantageusement, les plots de connexion sont disposés à la périphérie du substrat, à une distance inférieure à 5 millimètres du bord du substrat, ou de la ligne de coupe disposée dans ce dernier. Typiquement, ils sont disposés à une distance comprise entre 10 micromètre et 500 micromètres. Lorsque le capteur présente une forme polygonale, les plots de connexion sont de préférence alignés avec les bords du substrat, sur une ou plusieurs rangées. Les plots de connexion ont par exemple une forme rectangulaire avec des côtés de longueur comprise entre 50 micromètres (µm) et 70 µm, et des côtés de longueur comprise entre 150 µm et 210 µm. Ces caractéristiques permettent de faciliter la connexion avec les circuits externes précédemment évoqués.

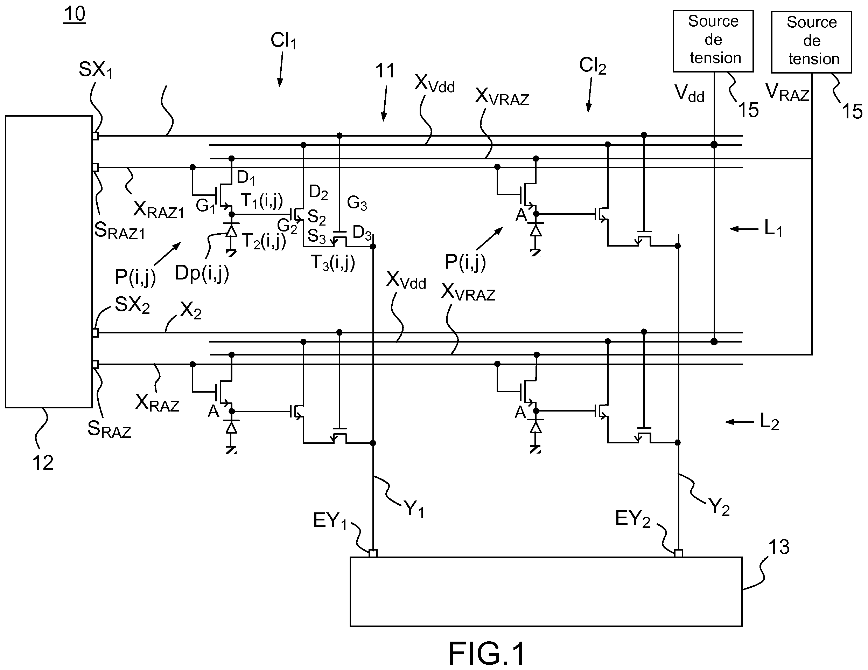

La figure 1 est un schéma fonctionnel d'un exemple de capteur d'images CMOS sur lequel repose l'invention. Le capteur d'images 10 comporte une matrice 11 de deux lignes L₁ et L₂ par deux colonnes Cl₁ et Cl₂ de pixels P₁ à P₄. Dans le présent exemple de capteur, les pixels comportent des éléments photosensibles et sont donc aussi appelés "points photosensibles". La matrice 11 pouvant comporter un nombre quelconque de lignes et de colonnes, on note les pixels sous la forme générique P(i,j), où i et j sont des entiers naturels désignant respectivement le rang de ligne et le rang de colonne dans la matrice 11. Le capteur d'images 10 comporte en outre un bloc 12 d'adressage de lignes, un bloc 13 de lecture de colonnes, des conducteurs de ligne Xᵢ, X_{RAZi}, X_{Vdd} et X_{VRAZ}, et des conducteurs de colonne Yⱼ. Le bloc 12 d'adressage de lignes comporte au minimum deux points de connexion SXᵢ et S_{RAZi} pour chaque ligne i de pixels P(i,j). Chaque point de connexion SXᵢ est connecté au conducteur de ligne Xᵢ correspondant et chaque point de connexion S_{RAZi} est connecté au conducteur de ligne X_{RAZi} correspondant. Un pixel P(i,j) comporte une photodiode Dp(i,j) et trois transistors T₁(i,j), T₂(i,j) et T₃(i,j). Les photodiodes Dp(i,j) peuvent naturellement être remplacées par tout élément photosensible apte à générer des charges électriques sous un rayonnement de photons. Le premier transistor T₁(i,j) est relié par sa grille G₁ au conducteur de ligne X_{RAZi} de la ligne i, par son drain D₁ au conducteur de ligne X_{VRAZ}, et par sa source S₁ à la cathode de la photodiode Dp(i,j). Les anodes de toutes les photodiodes Dp(i,j) sont reliées à un potentiel commun, par exemple la masse. Le point de connexion entre la source S₁ du transistor T₁(i,j) et la cathode de la photodiode Dp(i,j) est appelé point flottant A. Le transistor T₂(i,j) est relié par sa grille G₂ au point flottant A, par son drain D₂ au conducteur de ligne X_{Vdd} et par sa source S₂ à la source S₃ du transistor T₃(i,j). La grille G₃ du transistor T₃(i,j) est reliée au conducteur de ligne Xᵢ et son drain D₃ est relié au conducteur de colonne Yⱼ. Tous les conducteurs de ligne X_{VRAZ} sont soumis à un même potentiel, appelé potentiel de remise à zéro V_{RAZ}. Ce potentiel est par exemple fourni par une source de tension 14. De manière analogue, tous les conducteurs de ligne X_{Vdd} sont soumis à un même potentiel, appelé potentiel d'alimentation V_{dd}. Ce potentiel est par exemple fourni par une source de tension 15. Le bloc 12 d'adressage de lignes peut en outre comporter des éléments permettant de générer les signaux à injecter sur les conducteurs de ligne Xᵢ et X_{RAZi}. Il s'agit par exemple d'une horloge et de registres à décalage. Le bloc 13 de lecture de colonnes comporte au minimum un point de connexion EYⱼ pour chaque conducteur de colonne Yⱼ. Il peut en outre comporter des éléments permettant de traiter les signaux reçus sur les conducteurs de colonne Yⱼ. En particulier, il peut s'agir d'un multiplexeur, d'un amplificateur et/ou d'un convertisseur analogique - numérique.

Les transistors T₁(i,j) permettent de réinitialiser le potentiel de la cathode des photodiodes Dp(i,j) au potentiel de remise à zéro V_{RAZ}. En particulier, lorsque le signal injecté sur le conducteur de ligne X_{RAZi} d'une ligne i est actif, le potentiel du point flottant A de toutes les photodiodes Dp(i,j) de la ligne i est réinitialisé au potentiel V_{RAZ}. Les transistors T₂(i,j) fonctionnent en suiveur et les transistors T₃(i,j) permettent de sélectionner la ligne i de pixels P(i,j) pour lesquels on souhaite lire la quantité de charges électriques accumulées au point flottant A. Lorsque le signal injecté sur le conducteur de ligne Xᵢ d'une ligne i est actif, le potentiel des points flottants A est recopié, à une tension de décalage près, sur le conducteur de colonne Yⱼ correspondant. Le capteur d'images 10 fonctionne de la manière suivante. Lors d'une phase de prise d'image, intervenant de préférence après une opération de remise à zéro du potentiel des points flottants A, l'exposition des photodiodes Dp(i,j) à un rayonnement génère des charges électriques au niveau des points flottants A. La quantité de charges au niveau de chaque point flottant A est en général proportionnelle à l'intensité du rayonnement reçu par le pixel P(i,j) considéré. La phase de prise d'image est suivie d'une phase de lecture effectuée ligne par ligne. Les signaux injectés sur les différents conducteurs de ligne passent successivement à l'état actif, de sorte que le potentiel de chaque conducteur de colonne Yⱼ est successivement représentatif de la quantité de charges électriques accumulées dans les différents pixels P(i,j) de la colonne j.

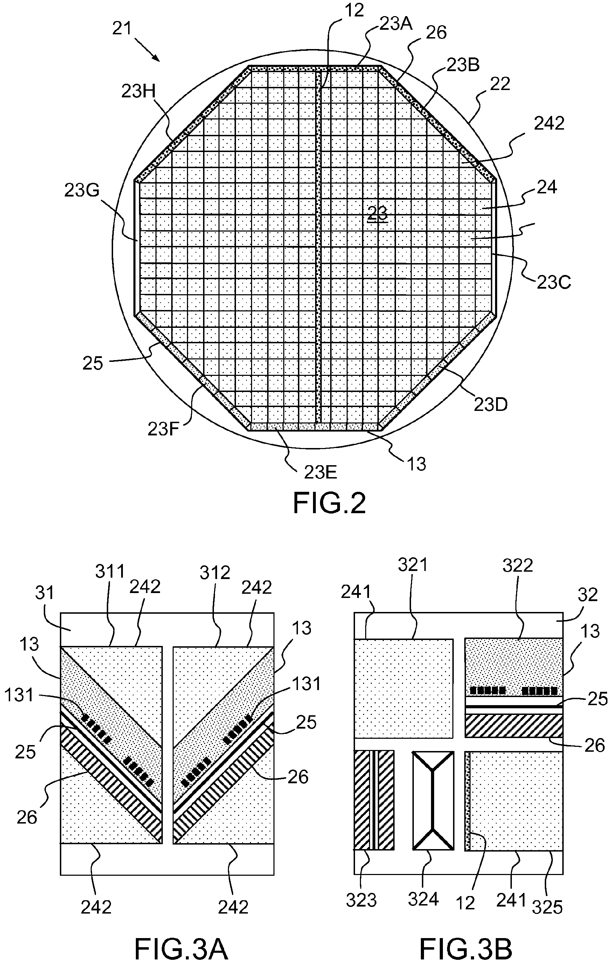

La figure 2 représente un premier exemple de réalisation d'un capteur selon l'invention. Ce capteur 21 est réalisé sur une plaquette semi-conductrice 22 de forme circulaire formant un substrat. Le capteur 21 comporte une zone photosensible 23 formée d'un ensemble de pixels 24 aboutés les uns aux autres en formant des lignes et des colonnes, des blocs 12 d'adressage de lignes, et des blocs 13 de lecture de colonnes. Les conducteurs de ligne, non représentés, relient chaque ligne de pixels 24 à l'un des blocs 12 d'adressage de lignes. Les conducteurs de colonne, non représentés, relient chaque colonne de pixels 24 à l'un des blocs 13 de lecture de colonnes. Dans ce premier exemple de réalisation, la zone photosensible 23 forme un octogone régulier. Les côtés de l'octogone sont notés consécutivement 23A à 23H, le côté 23A étant un côté parallèle aux lignes de pixels 24. La zone photosensible 23 comprend des pixels 241 de forme carrée, et des pixels 242 de forme triangulaire. Notons que l'on parle ici de pixel triangulaire, sachant qu'en pratique ces pixels 242 dits de forme triangulaire sont en réalité un groupe de pixels dans lequel chaque pixel a une forme quadrilatère mais le groupe de pixels a une forme sensiblement triangulaire, un des côtés étant en marche d'escaliers. La désignation de pixel triangulaire s'entend donc d'un groupe de pixel triangulaire. En particulier, les pixels 242 ont une forme de triangle rectangle isocèle. Les pixels à la périphérie de la zone photosensible 23 sont des pixels carrés 241 lorsqu'ils sont situés sur les côtés parallèles aux lignes ou aux colonnes de pixels 24, c'est-à-dire sur les côtés 23A, 23C, 23E et 23G, et des pixels triangulaires 242 lorsqu'ils sont situés sur des côtés inclinés par rapport aux lignes et aux colonnes de pixels 24, c'est-à-dire sur les côtés 23B, 23D, 23F et 23H. Les pixels triangulaires 242 sont orientés de manière à permettre à la zone photosensible 23 d'approcher au mieux la forme d'un octogone. Tous les autres pixels 24 sont des pixels carrés 241. À la vue de la figure 2, il apparaît clairement que les blocs 12 d'adressage de lignes et les blocs 13 de lecture de colonnes ne peuvent pas être simplement disposés à la périphérie de la zone photosensible 23 selon deux lignes perpendiculaires entre elles. Une telle disposition nécessiterait une plaquette 22 de diamètre largement supérieur au diamètre du cercle dans lequel s'inscrit la zone photosensible 23. Dans ce premier exemple de réalisation, les blocs 12 d'adressage de lignes sont situés à l'intérieur même de la zone photosensible 23. Ils forment une colonne disposée entre deux colonnes de pixels 24 et s'étendant entre les côtés 23A et 23E de l'octogone. Cette disposition présente l'avantage de permettre à tous les blocs 12 d'être alignés entre eux. En revanche, la zone photosensible 23 présente une discontinuité susceptible d'être perçue sur les images. Les blocs 13 de lecture de colonnes sont situés à la périphérie de la zone photosensible 23, sur les côtés 23D, 23E et 23F de l'octogone. Sur chacun de ces côtés, les blocs 13 sont alignés entre eux, de manière à suivre la forme octogonale. Certains blocs 13 de lecture de colonnes sont donc inclinés par rapport aux lignes et aux colonnes de pixels 24. Les blocs 12 et 13 comportent au minimum des plots de connexion permettant de connecter les conducteurs de ligne et de colonne avec des circuits extérieurs. Les plots de connexion des blocs 12 d'adressage de lignes sont par exemple formés par des trous métallisés, également appelés "vias", permettant des connexions par la face de la plaquette semi-conductrice 22 opposée à la face sur laquelle sont formés les pixels 24. Les blocs 13 de lecture de colonnes peuvent comporter, outre des plots de connexion, des circuits de traitement des signaux reçus sur les conducteurs de colonne. Ces circuits peuvent être disposés sur la même face de la plaquette semi-conductrice 22 que celle sur laquelle sont formés les pixels 24, ou sur la face opposée. De manière optionnelle, une ligne de découpe 25 entourant la zone photosensible 23 et les blocs 13 de lecture de colonnes peut être formée sur la plaquette semi-conductrice 22. Cette ligne de découpe 25, désignée en anglais sous l'expression "die seal ring", peut être réalisée par un empilement de couches métalliques renforçant localement la plaquette semi-conductrice et facilitant ainsi la découpe du capteur 21. La ligne de découpe 25 forme ainsi le bord du capteur 21. Le capteur 21 peut aussi comporter des blocs 26 de routage sur les côtés de la zone photosensible 23 laissés libres par les blocs 13 de lecture de colonnes. En l'occurrence, ces blocs 26 de routage peuvent être disposés sur les côtés 23A, 23B, 23C, 23G et 23H. Les blocs 26 de routage peuvent notamment être utilisés pour connecter des lignes d'alimentation, par exemple les conducteurs de ligne X_{VRAZ} et X_{Vdd} du capteur d'images 10 représenté sur la figure 1.

Il est à noter que, dans l'exemple de capteur 21 décrit ci-dessus, ainsi que dans les exemples de capteurs décrits ci-dessous, les pixels 24 sont représentés par des formes géométriques, à savoir des carrés ou des triangles. Cependant, il s'agit uniquement d'une représentation schématique. Les pixels 24 correspondent par exemple aux pixels P(i,j) décrits en référence à la figure 1. Ainsi, même si la surface d'un pixel est principalement occupée par son élément photosensible, elle est aussi occupée par d'autres éléments, en l'occurrence des transistors et des tronçons de conducteurs. Néanmoins, chaque pixel peut être conçu de manière à s'inscrire sensiblement dans la forme désirée. Par ailleurs, il a été considéré que chaque forme géométrique correspond à un unique pixel. Cependant, chaque carré et chaque triangle peut comporter une pluralité de pixels. On parle dans ce cas de blocs de pixels. À titre d'exemple, chaque élément désigné par la référence 241 dans la figure 2 peut comporter un bloc de deux lignes par deux colonnes de pixels, comme la matrice 11 de la figure 1, ou un bloc de 64x64 pixels. Chaque élément désigné par la référence 242 peut comporter un bloc de pixels de dimensions identiques disposés de manière à former un triangle. Par ailleurs, dans les différents exemples de capteurs décrits dans la présente demande, chaque bloc 12 d'adressage de lignes est représenté comme adressant une unique ligne de pixels ou, le cas échéant, une unique ligne de blocs de pixels. Cependant, il s'agit là encore d'une simple représentation. Un même bloc 12 d'adressage de lignes peut adresser plusieurs lignes de pixels ou plusieurs lignes de blocs de pixels. Dans le cas particulier du capteur 21, le même bloc 12 d'adressage peut adresser toutes les lignes de pixels de la zone photosensible 23. De même, un bloc 13 de lecture de colonnes peut adresser plusieurs colonnes de pixels ou plusieurs colonnes de blocs de pixels.

Pour la suite de la description, on appelle jeu de masques ou réticule un dispositif au travers duquel un rayonnement peut passer de manière à reproduire un motif sur une zone d'une plaquette semi-conductrice. Typiquement, la plaquette semi-conductrice est revêtue d'une résine photosensible et le rayonnement utilisé possède une longueur d'onde dans le domaine des ultraviolets. Les jeux de masques ou réticules ont une forme rectangulaire avec des dimensions par exemple de l'ordre de 26 mm par 32 mm. Pour réaliser un motif sur la plaquette semi-conductrice, on dispose d'au moins un jeu de masques comprenant plusieurs masques. Chaque masque d'un même jeu de masques définit une zone spatiale délimitée, correspondant à la zone de projection du rayonnement au travers du masque et sur la plaquette photosensible.

La projection du rayonnement au travers d'un masque permet la réalisation d'une partie du motif à réaliser. Le motif est ainsi réalisé par photolithographie, au moyen d'expositions successives au travers des différents masques d'un jeu de masque. Autrement dit, on forme un motif sur la plaquette semi-conductrice par des expositions successives dont chacune permet la réalisation d'un niveau technologique ; ces niveaux technologiques pouvant correspondre par exemple à un niveau d'implantation N ou P, un dépôt d'oxyde ou polysilicium, ou de métal oxyde. L'empilement de ces niveaux technologiques obtenus à l'issue des expositions successives au travers des masques du jeu de masques permet d'obtenir un motif opérationnel sur une zone de la plaquette semi-conductrice. Il va de soi qu'entre chaque exposition, des procédés microtechnologiques de type dépôt, gravure, dissolution...peuvent être mis en œuvre.

La zone image définissant à terme la surface du capteur photographique est obtenue en reproduisant sur la surface de la plaquette semi-conductrice un ou plusieurs motifs adjacents les uns aux autres. Autrement dit, les motifs sont destinés à être interconnectés de façon à constituer la zone image. Cette interconnexion entre les motifs constitue une difficulté particulière résolue par la présente invention comme décrit dans la suite.

Notons également que dans le procédé de photolithographie mis en œuvre, les masques d'un même jeu de masques peuvent être partiellement obturés de la même manière par des volets d'obturation pour délimiter la zone de projection du jeu de masques. Par le biais de cette obturation partielle du jeu de masques, il est envisagé qu'un même jeu de masques peut être configuré pour permettre de réaliser plusieurs motifs.

Autrement dit, pour réaliser un motif, chaque masque d'un même jeu de masque comporte une région délimitée dédiée à ce motif. Lors de la réalisation dudit motif sur la plaquette, chaque masque du jeu de masques est obturé, de façon ce que ladite région soit exposée. Ainsi, chaque masque d'un même jeu de masque peut comporter plusieurs régions, chaque région correspondant à un motif particulier.

Cette mise en œuvre est particulièrement avantageuse car le coût élevé d'un jeu de masques ou réticule constitue une contrainte de conception pour un capteur de grande dimension. Il convient de limiter le nombre de jeux de masques nécessaires pour la réalisation du capteur. La présente invention permet avantageusement d'optimiser ce nombre de jeux de masques tout en offrant une grande flexibilité de conception pour un capteur de grande dimension et présentant une géométrie complexe.

Les figures 3A et 3B représentent schématiquement un premier exemple de jeux de masques permettant de réaliser le capteur 21 de la figure 2. La figure 3A correspond à un premier jeu de masques et la figure 3B à un deuxième jeu de masques. Le premier jeu de masques 31 est apte à constituer deux motifs 311 et 312. Dans la suite de la description, les figures 3A, 3B, 4, 5A, 5B, 7A, 7B, 8A, 8B, 10A, 10B12A, 12B, 12C, 14A, 14B, 16 représentent des motifs susceptibles d'être réalisés par des jeux de masques. On comprend que chacune de ces figures représente le motif apte à être réalisé sur la plaquette par photolithographie, en mettant en œuvre un jeu de masques. Le motif 311 comporte une partie supérieure et une partie inférieure séparées par un tronçon de ligne de découpe 25. La partie supérieure correspond au côté 23F de la zone photosensible 23. Elle comprend une région permettant de former un un bloc triangulaire de pixels, ainsi qu'une région permettant de former le bloc 13 de lecture de colonnes associé à ce bloc de pixels. Le bloc 13 de lecture de colonnes comprend des plots de connexion 131 alignés au voisinage de son bord extérieur, c'est-à-dire à proximité du tronçon de ligne de découpe 25, parallèlement au tronçon de ligne de découpe 25. Dans cet exemple de réalisation, les plots de connexion 131 sont alignés sur une seule rangée. Cependant, ils pourraient aussi être alignés sur plusieurs rangées, de préférence toutes parallèles au tronçon de ligne de découpe 25. La partie inférieure correspond au côté 23B de la zone photosensible 23. Elle comprend une région permettant de former un bloc triangulaire de pixels, ainsi qu'une région permettant de former un bloc 26 de routage. Les blocs 13 et 26 du motif 311 s'étendent selon des axes inclinés par rapport aux lignes et aux colonnes de pixels. Le motif 312 est destiné à former les côtés 23D et 23H de la zone photosensible 23. Il présente une symétrie axiale par rapport au motif 311.

Ainsi, chaque masque du jeu de masques 31 comporte deux régions distinctes permettant respectivement la réalisation, par photolithographie, de deux motifs 311, 312.

L'axe de symétrie étant un axe parallèle aux colonnes de pixels. Le deuxième jeu de masques 32 est apte à constituer cinq motifs 321 à 325. Le premier motif 321 est destiné à former un pixel carré 241 ou, le cas échéant, un bloc carré de pixels. Le motif 322 comporte une partie supérieure et une partie inférieure séparées par un tronçon de ligne de découpe 25 parallèle aux lignes de pixels. La partie supérieure correspond au côté 23E de la zone photosensible 23. Elle comporte une région permettant de former un bloc 13 de lecture de colonnes, et notamment des plots de connexion 131 alignés avec le tronçon de ligne de découpe 25. La partie inférieure correspond au côté 23A et comporte une partie permettant de former un bloc 26 de routage. Les blocs 13 et 26 du motif 322 s'étendent parallèlement aux lignes de pixels. Le motif 323 comporte une région permettant de former un bloc 26 de routage de part et d'autre d'un tronçon de la ligne de découpe 25. Il permet de former les côtés 23C et 23G de la zone photosensible 23. Le motif 324 est destiné à former les jonctions de la ligne de découpe 25 entre les différents côtés du polygone. Le motif 325 comporte une région permettant de former un bloc carré de pixels, et une région permettant de former un bloc 12 d'adressage de lignes accolé à l'un des côtés du pixel 241 parallèles aux colonnes de pixels. L'une des particularités des jeux de masques 31 et 32 est d'être adaptés à la réalisation de motifs présentant des formes inclinées par rapport aux lignes et aux colonnes de pixels de la zone photosensible 23. Ainsi, il est possible de réaliser une zone photosensible dont les contours sont inclinés avec un jeu de masques de forme rectangulaire. Cet avantage revêt une importance particulière dans la mesure où les procédés de lithographie actuels ne permettent pas d'orienter les masques par rapport à la plaquette semi-conductrice 22.

On note que chaque masque du jeu de masques 32 comporte cinq régions distinctes permettant respectivement la réalisation, par photolithographie, de cinq motifs 321, 322, 323, 324, 325.

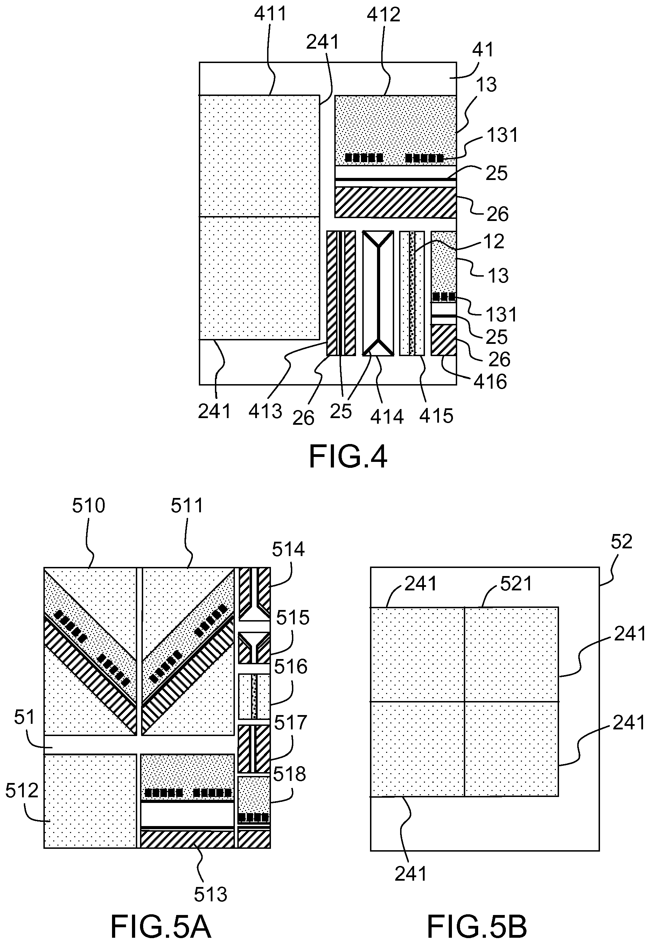

La figure 4 représente un deuxième exemple de jeu de masques permettant de réaliser le capteur 21 de la figure 2. Ce jeu de masques 41 est utilisé avec le jeu de masques 31 de la figure 3A. Il est apte à réaliser six motifs 411 à 416. Le premier motif 411 permet de former deux blocs carrés de pixels 241. Le deuxième motif 412 est identique au motif 322 correspondant jeu de masques 32. Les motifs 413 et 414 ont une structure identique aux motifs 323 et 324 mais présentent une largeur inférieure. Le motif 415 correspond à un bloc 12 d'adressage de lignes. Le motif 416 possède une structure identique aux motifs 322 et 412 mais présente une largeur inférieure. L'avantage d'utiliser le jeu de masques correspondant au motifs 411 à 416 à la place du jeu de masques 32 est que le nombre de photo-répétitions nécessaires est largement diminué du fait de la présence d'un motif comportant une région 411 permettant de former deux blocs de pixels carrés lors d'une même exposition du réticule On note que chaque masque du jeu de masques 41 comporte six régions distinctes permettant respectivement la réalisation, par photolithographie, de six motifs 411,412,413, 414 et 415.

Les figures 5A et 5B représentent un troisième exemple de jeux de masques permettant de réaliser le capteur 21 de la figure 2. La figure 5A représente un premier jeu de masques 51, permettant la réalisation des dix motifs 510 à 519 et la figure 5B un deuxième jeu de masques 52, permettant la réalisation d'un ou plusieurs. Le premier jeu de masques 51 comporte dix motifs 510 à 519. Les motifs 510, 511 et 512 sont respectivement identiques aux motifs 311, 312 et 321 des jeux de masques 31 et 32. Le motif 513 comporte une région permettant de former un bloc 13 de lecture de colonnes avec des plots de connexion 131 et un tronçon de ligne de découpe 25 parallèles aux lignes de pixels. Il comporte aussi une région permettant de former un bloc 26 de routage et un tronçon de ligne de coupe 25 parallèles aux lignes de pixels. Les motifs 514, 515 et 517 permettent chacun de former deux blocs 26 de routage orientés parallèlement aux colonnes de pixels et des tronçons de ligne de découpe 25. Le motif 516 permet d'imprimer un bloc 12 d'adressage de lignes parallèle aux colonnes de pixels. Le motif 518 est sensiblement identique au motif 513. Il en diffère par une largeur inférieure. Le deuxième jeu de masques 52 comporte un unique motif 521 permettant de former quatre blocs carrés de pixels 241. Le premier jeu de masques 51 peut être utilisé seul pour former l'ensemble du capteur 21. L'inconvénient de ce jeu de masques est que les dimensions du motif 512, représentant un bloc carré de pixels, sont relativement limitées. Ainsi, le deuxième jeu de masques 52 peut être utilisé, en complément, pour minimiser le nombre de photo-répétitions

On note que chaque masque du jeu de masques 51 comporte dix régions distinctes permettant respectivement la réalisation, par photolithographie, de dix motifs 510, 511, 512, 513, 514, 515, 516, 517, 518. Chaque masque du jeu de masques 52 comporte une région, permettant la réalisation d'un motif 521, ce dernier correspondant à quatre motifs 241 adjacents.

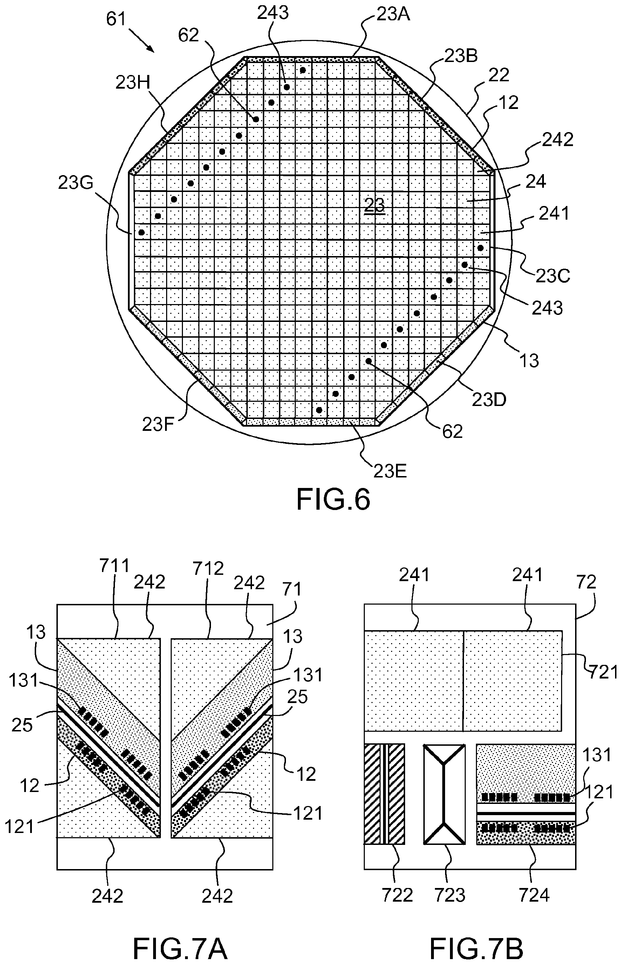

La figure 6 représente un deuxième exemple de réalisation d'un capteur selon l'invention. Ce capteur 61 diffère principalement du capteur 21 de la figure 2 par la disposition des blocs 12 d'adressage de lignes. Le capteur 61 comporte également des blocs de pixels 24 de forme carrée ou triangulaire qui forment une zone photosensible 23 octogonale. Les blocs 13 de lecture de colonnes sont aussi situés sur trois côtés adjacents, en l'occurrence les côtés 23D à 23F. Les blocs 12 d'adressage de lignes sont situés sur les côtés opposés de l'octogone, à savoir sur les côtés 23H, 23A et 23B, respectivement. Sur chacun de ces côtés, les blocs 12 sont alignés entre eux. Afin de permettre d'adresser chaque ligne de pixels, le capteur 61 comporte en outre des bus de commande et des trous métallisés 62 réalisés au sein de la zone photosensible 23. En particulier, des trous métallisés sont présents dans certains pixels 24, appelés pixels de vias 243. Une première série de trous métallisés est réalisée entre le milieu du côté 23G et le milieu du côté 23A, et une deuxième série de trous métallisés est réalisée entre le milieu du côté 23E et le milieu du côté 23C. Les pixels 24 et les conducteurs de ligne sont formés sur une première couche métallisée de la plaquette semi-conductrice 22, en l'occurrence l'une de ses faces extérieures. Les bus de commande sont formés sur une autre couche métallisée de la plaquette semi-conductrice 22, par exemple sur la face extérieure opposée. Ils sont orientés parallèlement aux colonnes de pixels et sont reliés aux blocs 12 d'adressage de lignes. Chaque trou métallisé 62 connecte l'un des conducteurs de ligne à l'un des bus de commande. Les trous métallisés 62 de la première série permettent d'adresser les lignes de pixels de la moitié supérieure du capteur 61 et les trous métallisés de la deuxième série permettent d'adresser les lignes de pixels de la moitié inférieure. Sur la figure 6, par souci de clarté, seulement un trou métallisé par pixel de vias 243 est représenté. Cependant, un pixel de vias 243 comprend autant de trous métallisés que de conducteurs de ligne. Pour un capteur comprenant des pixels tels que ceux représentés sur la figure 1, chaque pixel de vias 243 comprend deux trous métallisés, un premier pour connecter un conducteur Xᵢ et un deuxième pour connecter le conducteur X_{RAZi}. En outre, dans le cas où la référence 24 désigne des blocs de pixels plutôt qu'un pixel unique, chaque représentation de trou métallisé 62 doit être interprétée comme correspondant à un ensemble de trous métallisés. De manière générale, le capteur 62 comporte un nombre de trous métallisés égal au nombre total de conducteurs de lignes.

Les figures 7A et 7B représentent un premier exemple de jeux de masques permettant de réaliser le capteur 61 de la figure 6. Le jeu de masques 71 représenté sur la figure 7A permet la réalisation de deux motifs 711 et 712. Le motif 711 est sensiblement identique au motif 311 de la figure 3A, sauf en ce qu'il comporte une région permettant de former un bloc 12 d'adressage de ligne à la place de la région permettant de former un bloc 26 de routage. Ainsi, la partie supérieure permet de former un pixel triangulaire 242 et un bloc 13 de lecture de colonnes incliné, et la partie inférieure permet de former un bloc 12 d'adressage de lignes incliné et un bloc triangulaire de pixels 242. Le bloc 12 d'adressage de lignes comprend des plots de connexion 121 alignés avec le tronçon de ligne de découpe 25. Le motif 712 présente une symétrie axiale par rapport au motif 711 selon un axe parallèle aux colonnes de pixels. Le jeu de masques 72 représenté sur la figure 7B permet la réalisation de quatre motifs 721 à 724. Le premier motif 721 correspond à deux blocs de pixels carrés 241. Les motifs 722 et 723 correspondent respectivement aux motifs 323 et 324 correspondant au jeu de masques 32. Le motif 724 comporte une région permettant de former un bloc 13 de lecture de colonnes, une région permettant de former un tronçon de ligne de découpe 25 et une région permettant de former un bloc 12 d'adressage de lignes.

On note que chaque masque du jeu de masques 71 comporte deux régions distinctes permettant respectivement la réalisation, par photolithographie, de deux motifs 711 et 712. Chaque masque du jeu de masques 72 comporte dix régions distinctes permettant respectivement la réalisation, par photolithographie, de quatre motifs 721, 722, 723 et 724.

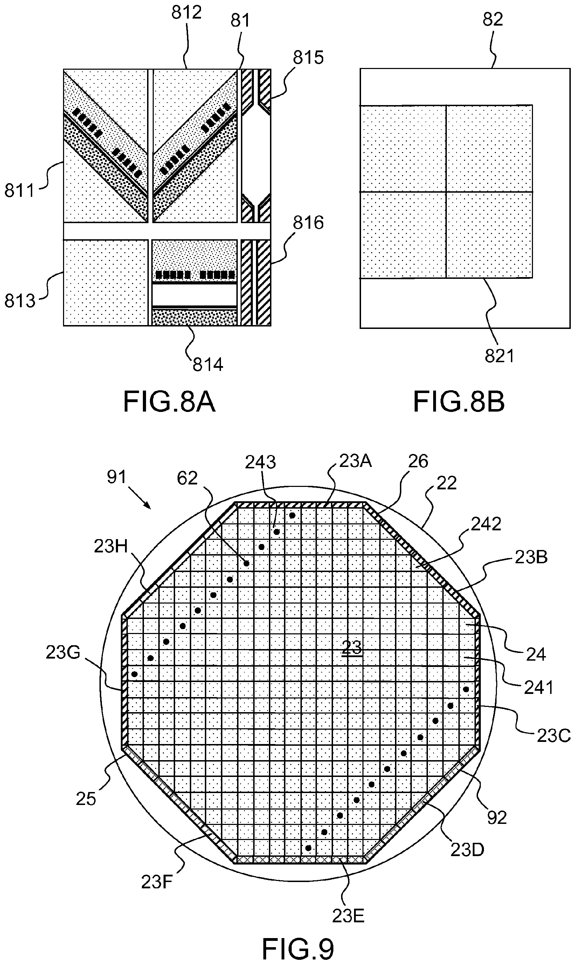

Les figures 8A et 8B représentent un deuxième exemple de jeux de masques permettant de réaliser le capteur 61 de la figure 6. Le jeu de masques 81 représenté sur la figure 8A permet de réaliser six motifs 811 à 816. Les motifs 811 et 812 sont sensiblement identiques aux motifs 711 et 712 du jeu de masques 71, mais ont des dimensions légèrement inférieures afin de laisser de la place sur le jeu de masques pour d'autres motifs. Le motif 813 permet de former un motif carré 241. Le motif 814 comporte une partie supérieure permettant de former un bloc 13 de lecture de colonnes parallèle aux lignes de pixels et un tronçon de ligne 25, et une partie inférieure permettant de former un bloc 12 d'adressage de lignes parallèle aux lignes de pixels et un tronçon de ligne 25. Le motif 815 comporte quatre régions permettant de former des extrémités de blocs 26 de routage. Le motif 816 comporte deux blocs 26 de routage parallèles aux colonnes de pixels et deux tronçons de ligne 25. Le jeu de masques 82 représenté sur la figure 8B comporte un unique motif permettant de former quatre pixels carrés 241. Le jeu de masques 81 peut être utilisé seul pour former l'ensemble du capteur 61.

La figure 9 représente un troisième exemple de réalisation d'un capteur selon l'invention. Ce capteur 91 diffère principalement du capteur 61 de la figure 6 en ce que les blocs 12 d'adressage de lignes sont situés sur les mêmes côtés que les blocs 13 de lecture de colonnes, en l'occurrence sur les côtés 23D à 23F. Autrement dit, les blocs 12 et 13 sont fusionnés dans des blocs communs, appelés blocs 92 d'adressage commun. Un premier avantage de ce capteur 91 par rapport au capteur 61 est qu'il laisse davantage de côtés libres pour disposer des blocs 26 de routage. Un deuxième avantage est que toutes les connexions peuvent être réalisées sur trois côtés du capteur octogonal.

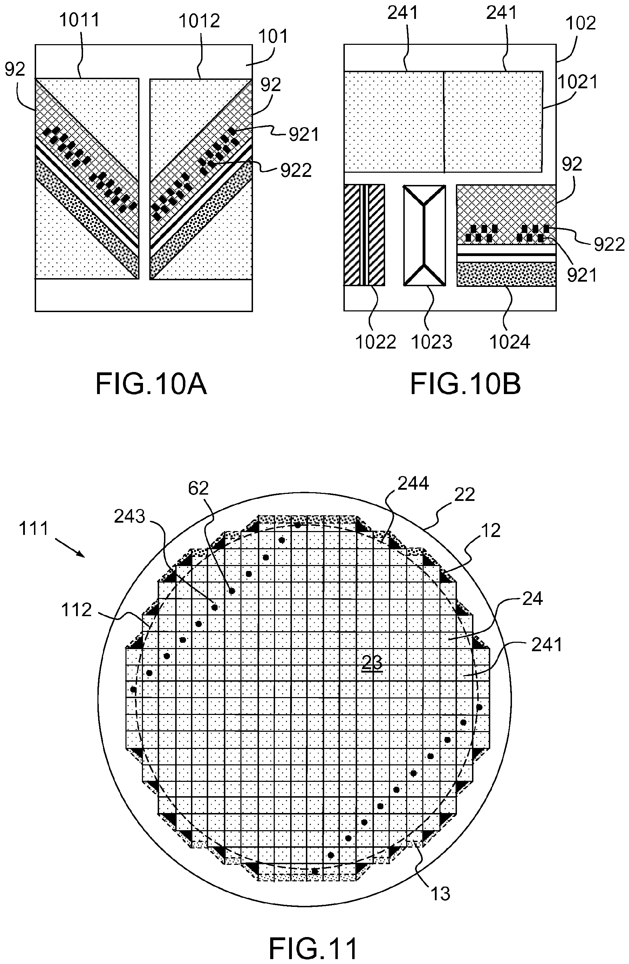

Les figures 10A et 10B représentent un exemple de jeux de masques permettant de réaliser le capteur 91 de la figure 9. Le jeu de masques 101 représenté sur la figure 10A permet de réaliser deux motifs 1011 et 1012. Ces motifs sont respectivement identiques aux motifs 311 et 312 du jeu de masques 31, sauf en ce que les régions permettant de former des blocs 13 de lecture de colonnes sont remplacées par des régions permettant de former des blocs 92 d'adressage commun. Ces blocs 92 comportent par exemple une première rangée de plots de connexion 921 permettant la connexion des conducteurs de ligne, et une deuxième rangée de plots de connexion 922 permettant la connexion des conducteurs de colonne. Le jeu de masques 102 représenté sur la figure 10B permet de réaliser quatre motifs 1021 à 1024. Le motif 1021 est formé d'une région permettant de former deux pixels carrés 241. Les motifs 1022 et 1023 sont respectivement identiques aux motifs 323 et 324 du jeu de masques 32. Le motif 1024 est identique au motif 322 sauf en ce que la région permettant de former un bloc 13 de lecture de colonnes est remplacée par une région permettant de former un bloc 92 d'adressage commun avec des plots de connexion 921 et 922.

La figure 11 représente un quatrième exemple de réalisation d'un capteur selon l'invention. Ce capteur 111 peut s'apparenter au capteur 61 de la figure 6. Il en diffère principalement en ce que la zone photosensible 23 n'est pas octogonale et en ce qu'elle est uniquement formée par des blocs de pixels de forme rectangulaire. En particulier, la zone photosensibles 23 est formée par des blocs de pixels carrés 241, par des pixels de vias 243 et par des pixels rectangulaires non carrés, appelés demi-pixels 244. Ces pixels 241, 243 et 244 sont agencés de manière à suivre au plus près la forme d'un cercle 112. Il est rappelé que les références 241, 243 et 244 peuvent aussi désigner des blocs de pixels. Des blocs 12 d'adressage de ligne sont disposés à la périphérie de la zone photosensible 23, en formant sensiblement un demi-cercle. Des blocs 13 de lecture de colonnes sont disposés à la périphérie de la zone photosensible 23, en formant sensiblement un demi-cercle, à l'opposé du demi-cercle formé par les blocs 12 d'adressage de lignes. Certains blocs 12 et 13 sont orientés parallèlement aux lignes de pixels 24, et d'autres sont inclinés par rapport aux lignes et aux colonnes de pixels 24. Les blocs 12 et 13 peuvent notamment être inclinés pour des colonnes dont le nombre de pixels est différent de celui des colonnes adjacentes.

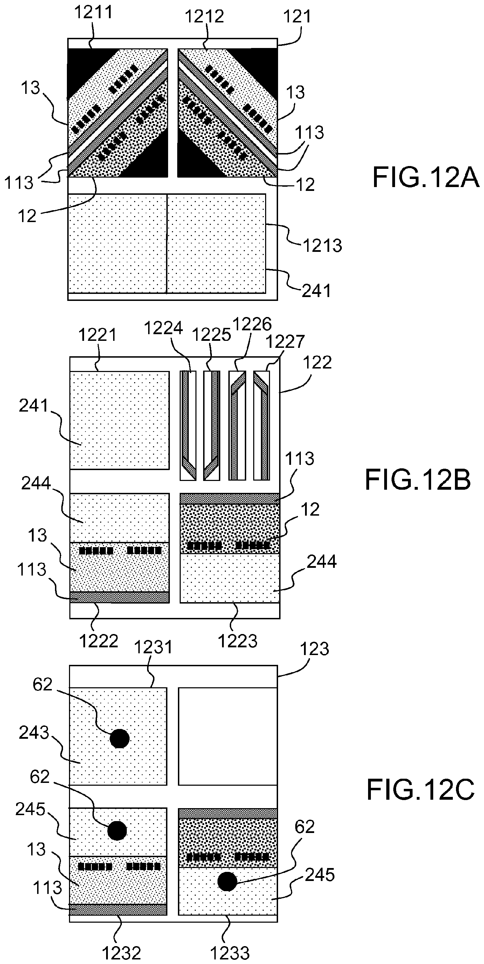

Les figures 12A, 12B et 12C représentent un exemple de jeux de masques permettant de réaliser le capteur 111 de la figure 11. Le jeu de masques 121 représenté sur la figure 12A permet de réaliser trois motifs 1211 à 1213. Le premier motif 1211 comprend une région permettant de former un bloc 13 de lecture de colonnes incliné et une région permettant de former une ligne de liaison 113 adjacente au bloc 13. Il comprend également une région permettant de former un bloc 12 d'adressage de lignes incliné et une région permettant de former une ligne de liaison 113 adjacente au bloc 12. Les lignes de liaison 113 permettent d'assurer une continuité entre les blocs 12 ou entre les blocs 13 lors d'une discontinuité du nombre de pixels par colonne. Le motif 1212 est le symétrique du motif 1211 par symétrie selon un axe orienté parallèlement aux colonnes de pixels. Le motif 1213 comprend une région permettant de former deux pixels carrés 241. Le jeu de masques 122 permet de réaliser sept motifs 1221 à 1227. Le motif 1221 permet de former un pixel carré 241. Le motif 1222 permet de former un demi-pixel 244 allongé dans le sens des lignes de pixels, un bloc 13 de lecture de colonnes adjacent au demi-pixel 244, et une ligne de liaison 113 adjacente au bloc 13. Le motif 1223 permet de former un demi-pixel 244 allongé dans les sens des lignes de pixels, un bloc 12 d'adressage de lignes adjacent au demi-pixel 244, et une ligne de liaison 113 adjacente au bloc 12. Les motifs 1224 à 1227 permettent de former différentes lignes de liaison comportant chacune une portion alignée parallèlement aux colonnes de pixels, et une portion inclinée par rapport aux lignes et aux colonnes de pixels. Le jeu de masques 123 permet de réaliser trois motifs 1231 à 1233 identiques aux motifs 1221 à 1223, sauf en ce que le pixel carré 241 est remplacé par un pixel de via 243, et en ce que chaque demi-pixel 244 est remplacé par un demi-pixel de via 245, c'est-à-dire un demi-pixel comprenant un trou métallisé 62.

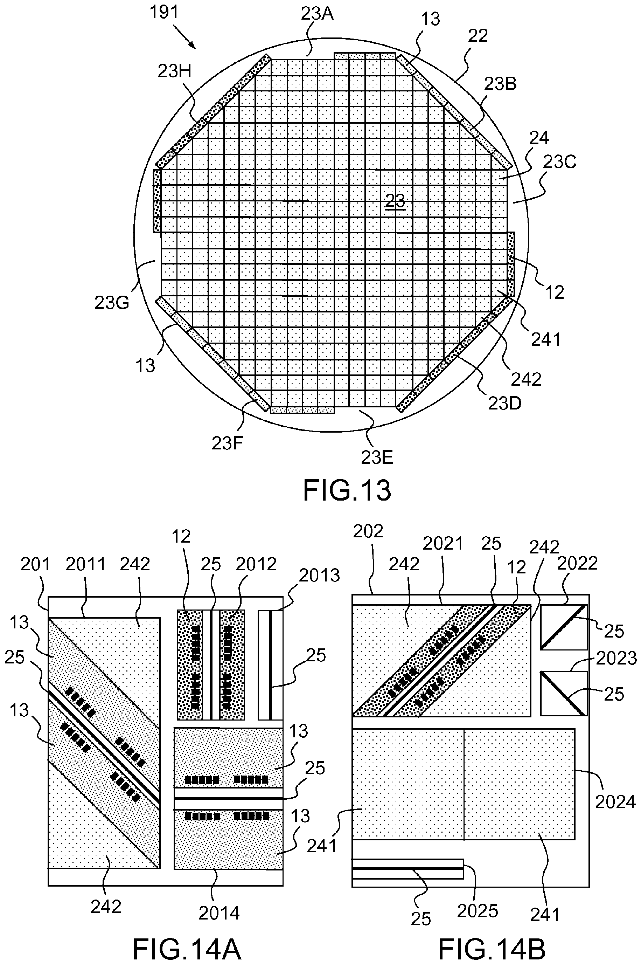

La figure 13 représente un cinquième exemple de réalisation d'un capteur selon l'invention. Ce capteur 191 comprend une zone photosensible 23 octogonale formée de pixels carrés 241 et triangulaires 242. Les blocs 12 d'adressage de lignes sont situés à la périphérie de la zone photosensible 23, sur le côté 23D de l'octogone, sur la moitié du côté 23C adjacente au côté 23D, sur le côté 23H, et sur la moitié du côté 23G adjacente au côté 23H. De manière plus générale, les blocs 12 d'adressage de lignes sont situés sur un premier et un deuxième côté de l'octogone, opposés entre eux, sur une partie d'un troisième côté, adjacent au premier côté, et sur une partie d'un quatrième côté, opposé au troisième côté, les deux parties étant complémentaires l'une de l'autre afin de permettre l'adressage de toutes les lignes de pixels 24. Il est notamment possible que l'une des parties occupe tout un côté, les blocs 12 étant alors situés sur seulement trois côtés de l'octogone. De manière analogue, les blocs 13 de lecture de colonnes sont situés sur un cinquième et un sixième côté, opposés entre eux, sur une partie d'un septième côté, adjacent au cinquième côté, et sur une partie complémentaire d'un huitième côté. En l'occurrence, les blocs 13 sont situés sur les côtés 23B et 23F, sur la moitié du côté 23A adjacente au côté 23B et sur la moitié 23E adjacente au côté 23F. Une ligne de découpe 25, non représentée, peut également être formée sur la plaquette semi-conductrice 22 de manière à entourer la zone photosensible et les blocs 12 et 13.

Les figures 14A et 14B représentent un exemple de jeux de masques permettant de réaliser le capteur 191 de la figure 13. Le jeu de masques 201 représenté sur la figure 14A permet de réaliser quatre motifs 2011 à 2014. Le motif 2011 comprend une partie supérieure et une partie inférieure séparées par un tronçon de ligne de découpe 25 incliné par rapport aux lignes et aux colonnes de pixels. Chaque partie comporte une région permettant de former un bloc 13 de lecture de colonnes incliné et un bloc triangulaire de pixels 242. Le motif 2012 comprend deux blocs 12 d'adressage de lignes orientés parallèlement aux colonnes de pixels et séparés par un tronçon de ligne de découpe 25. Le motif 2013 comporte une région permettant de former un tronçon de ligne de découpe 25 orienté parallèlement aux colonnes. Le motif 2014 comporte deux blocs 13 de lecture de colonnes orientés parallèlement aux lignes de pixels et séparés par un tronçon de ligne de découpe 25. Le jeu de masques 202 représenté sur la figure 14B comporte cinq motifs 2021 à 2025. Le motif 2021 comporte une partie gauche et une partie droite séparées par un tronçon de ligne de découpe 25 incliné par rapport aux lignes et aux colonnes de pixels. Chaque partie comporte une région permettant de former un bloc 12 d'adressage de lignes incliné et un pixel triangulaire 242. Les motifs 2022 et 2023 permettent de former des tronçons de ligne de découpe 25 inclinés. Le motif 2024 comporte deux blocs de pixels carrés 241 et le motif 2025 permet de former un tronçon de ligne de découpe 25 orienté parallèlement aux lignes de pixels.

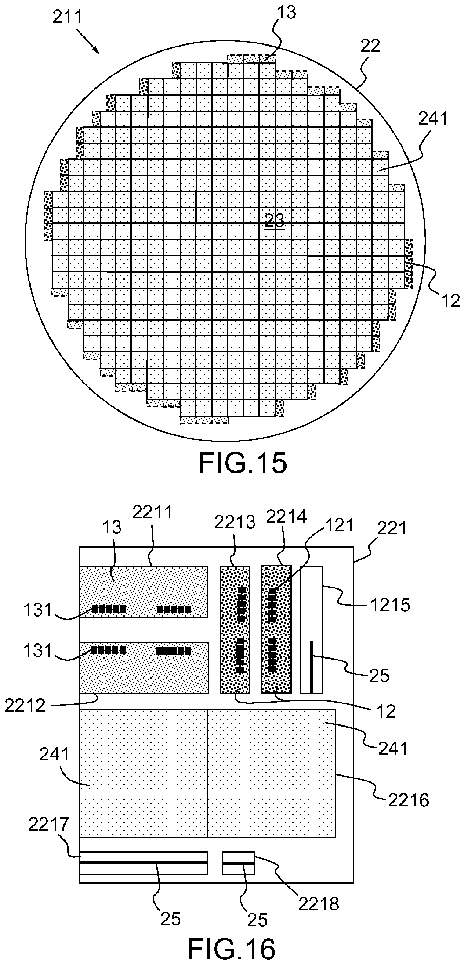

La figure 15 représente un sixième exemple de réalisation d'un capteur selon l'invention. Ce capteur 211 comprend une zone photosensible 23 formée uniquement de blocs de pixels carrés 241. Une partie des blocs 12 d'adressage de lignes est située à l'une des extrémités des lignes de pixels, et le reste des blocs 12 d'adressage de lignes est situé à l'extrémité opposée des lignes de pixels. Plus précisément, dans cet exemple de réalisation, les blocs 12 d'adressage de lignes sont situés à l'extrémité gauche des lignes de pixels sur la moitié supérieure du capteur 211, et à l'extrémité droite sur la moitié inférieure. De manière analogue, une partie des blocs 13 de lecture de colonnes est située à une première extrémité des colonnes de pixels, et le reste des blocs 13 d'adressage de colonnes est situé à la deuxième extrémité des colonnes de pixels. En l'occurrence, les blocs 13 d'adressage de colonnes sont situés à l'extrémité inférieure des colonnes de pixels sur la partie gauche du capteur 211, et à l'extrémité supérieure sur la partie droite. Les blocs 12 d'adressage de lignes sont ainsi alignés avec les colonnes de pixels, et les blocs 13 avec les lignes de pixels.

La figure 16 représente un exemple de jeu de masques permettant de réaliser le capteur 211 de la figure 15. Le jeu de masques 221 permet de réaliser huit motifs 2211 à 2218. Le motif 2211 permet de former un bloc 13 de lecture de colonnes pour la partie gauche du capteur 211. Les plots de connexion 131 de ce bloc 13 sont situés à proximité de sa partie inférieure. Le motif 2212 permet de former un bloc 13 de lecture de colonnes pour la partie droite du capteur 211. Les plots de connexion 131 de ce bloc sont situés à proximité de sa partie supérieure. Les motifs 2213 et 2214 permettent de former des blocs 12 d'adressage de lignes pour les parties inférieure et supérieure, respectivement, du capteur 211. Les plots de connexion 121 du bloc 12 formé par le motif 2213 sont situés à proximité de sa partie droite, et les plots de connexion 121 du bloc 12 formé par le motif 2214 sont situés à proximité de sa partie gauche. Le motif 2215 permet de former un tronçon de ligne de découpe 25 orienté parallèlement aux colonnes de pixels. Les motifs 2217 et 2218 permettent de former des tronçons de ligne de découpe 25 orientés parallèlement aux lignes de pixels. Et le motif 2216 permet de former deux pixels carrés 241.

## Revendications

1. Procédé de réalisation par photolithographie d'un dispositif imageur sur une plaquette semi-conductrice (22) formant un substrat ; le capteur comprenant :
• une zone image (23) réalisée sur le substrat et comprenant un ensemble de pixels (24) agencés selon des lignes et des colonnes, le nombre de pixels par colonne n'étant pas uniforme pour toutes les colonnes de pixels, chaque pixel (24) comprenant un élément collecteur de charges collectant des charges électriques générées en fonction d'un rayonnement photonique reçu par le dispositif imageur,
• des conducteurs de ligne (Xᵢ, X_{RAZi}) reliant les pixels ligne par ligne,
• des conducteurs de colonne (Yⱼ) reliant les pixels colonne par colonne,
• des blocs (12) d'adressage de lignes reliés aux conducteurs de lignes (Xᵢ, X_{RAZi}) et permettant d'adresser individuellement chaque ligne de pixels, et
• des blocs (13) de lecture de colonnes reliés aux conducteurs de colonne (Yⱼ) et permettant de lire les charges électriques collectées par les pixels (24) de la ligne sélectionnée par les blocs (12) d'adressage de lignes, les blocs (13) de lecture de colonnes étant situés à la périphérie de la zone image (23),
• les blocs (12) d'adressage de lignes et les blocs (13) de lecture de colonnes étant réalisés sur le même substrat (22) que la zone image ; le procédé comprenant en outre une étape dans laquelle une surface de la plaquette semi-conductrice (22) est exposée zone par zone à un rayonnement au travers de deux ou trois jeux de masques ; chaque jeu de masques comprenant plusieurs masques ; chaque masque d'un même jeu de masques comportant plusieurs régions, chaque région correspondant à un motif particulier ; les deux ou trois jeux de masques étant configuré pour pouvoir réaliser, par photolithographie, différents motifs sur la surface de la plaquette semi-conductrice (22) ; la zone image étant obtenue par la réalisation successive de motifs, adjacents les uns aux autres, sur la surface de la plaquette semi-conductrice ; la zone image (23) ainsi obtenue présentant une superficie supérieure ou égale à 10 cm² ;
le procédé étant également **caractérisé en ce que** le nombre de motifs mis en œuvre est strictement supérieur à 1 et inférieur à 15.

2. Procédé selon la revendication 1, dans lequel chaque masque des deux ou trois jeux de masques comporte n régions distinctes, permettant respectivement la réalisation, par photolithographie, de n motifs ; n étant un entier compris entre 1 et 15.

3. Procédé selon l'une des revendications 1 ou 2, dans lequel le nombre de motifs mis en œuvre est inférieur à 8.

4. Procédé selon l'une des revendications 1 à 3, dans lequel les pixels périphériques de la zone image forment sensiblement un polygone comprenant au moins 5 côtés.

5. Procédé selon l'une des revendications 1 à 4, dans lequel les pixels périphériques de la zone image forment sensiblement un polygone comprenant un nombre de côtés inférieur à 20.

6. Procédé selon l'une des revendications 1 à 5, dans lequel les pixels périphériques de la zone image forment sensiblement un octogone régulier.

7. Procédé selon l'une des revendications 1 à 6, dans lequel chaque bloc (12) d'adressage de lignes du capteur (61) est formé par la réalisation d'un motif (711, 712, 724) comprenant une région correspondant audit bloc (12) d'adressage de lignes, au moins l'un des motifs (711, 712) formant un bloc d'adressage de lignes présentant des formes inclinées par rapport aux lignes et aux colonnes de pixels.

8. Procédé selon l'une des revendications 1 à 7, dans lequel chaque bloc (13) de lecture de colonnes du capteur (21) est formé par la réalisation d'un motif (311, 312, 322) comprenant une région correspondant audit bloc (13), au moins l'un des motifs (311, 312) formant un bloc de lecture de colonnes présentant des formes inclinées par rapport aux lignes et aux colonnes de pixels.

9. Procédé selon l'une des revendications 1 à 8, dans lequel les deux ou trois jeux de masques (31, 32) sont de forme rectangulaire, chaque motif à réaliser sur la plaquette semi-conductrice (22) étant sélectionné par un ou plusieurs volets d'obturation.

10. Procédé selon l'une des revendications 1 à 9, dans lequel la surface de la plaquette semi-conductrice (22) est exposée au travers des deux ou trois jeux de masques (311, 312, 322, 323, 324), dont chaque masque comporte une région permettant de former une ligne de découpe (25) entourant la zone image (23), les blocs (12) d'adressage de lignes et les blocs (13) de lecture de colonnes ; la ligne de découpe (25) facilitant la découpe de la plaquette semi-conductrice (22) ; le procédé comprenant, en outre, une étape de découpe de la plaquette semi-conductrice (22) le long de la ligne de découpe (25) pour former le capteur (21, 61, 91, 111, 191).

11. Procédé selon l'une des revendications 1 à 10, dans lequel au moins deux blocs (13) de lecture de colonnes sont contigus à des pixels (24) appartenant à des lignes de rangs distincts.

12. Procédé selon l'une des revendications 4 ou 5, dans lequel les blocs (13) de lecture de colonnes sont regroupés par ensembles, chaque ensemble étant parallèle à l'un des côtés (23D, 23E, 23F) du polygone.

13. Procédé selon les revendications 6 et 12, dans lequel les blocs (13) de lecture de colonnes d'un premier ensemble sont situés sur un premier côté (23D) de l'octogone régulier, les blocs (13) de lecture de colonnes d'un deuxième ensemble sont situés sur un deuxième côté (23E) adjacent au premier, et les blocs (13) de lecture de colonnes d'un troisième ensemble sont situés sur un troisième côté (23F) adjacent au deuxième côté.

14. Procédé selon l'une des revendications 1 à 13, dans lequel les blocs (12) d'adressage de lignes sont situés à la périphérie de la zone image (23).

15. Procédé selon les revendications 13 et 14, dans lequel les blocs (12) d'adressage de lignes sont situés sur des côtés (23A, 23B, 23H) de l'octogone régulier opposés au premier, au deuxième et au troisième côté (23D, 23E, 23F), les conducteurs de ligne étant formés sur une première face du substrat (22), le capteur (61) comprenant, en outre, des bus de commande formés sur une deuxième face (couche métallique) du substrat et des trous métallisés (62) formés dans la zone image (23), les bus de commande étant orientés parallèlement aux colonnes de pixels et étant reliés aux blocs (12) d'adressage de lignes, les trous métallisés (62) reliant chaque conducteur de ligne (Xᵢ, X_{RAZi}) à l'un des bus de commande.

16. Procédé selon les revendications 13 et 14, dans lequel les blocs (92) d'adressage de lignes sont situés sur les mêmes cotés (23D, 23E, 23F) de l'octogone régulier que les blocs (92) de lecture de colonnes, les conducteurs de ligne étant formés sur une première face (couche métallique) du substrat, le capteur (91) comprenant, en outre, des bus de commande formés sur une deuxième face (couche métallique) du substrat et des trous métallisés (62) formés dans la zone image (23), les bus de commande étant orientés parallèlement aux colonnes de pixels et étant reliés aux blocs (92) d'adressage de lignes, les trous métallisés (62) reliant chaque conducteur de ligne (Xᵢ, X_{RAZi}) à l'un des bus de commande.

17. Procédé selon les revendications 13 et 14, dans lequel les blocs (13) de lecture de colonnes sont situés sur une partie d'un premier côté (23A) de l'octogone régulier, sur un deuxième côté (23B) adjacent au premier côté (23A), sur une partie d'un troisième côté (23E), opposé au premier côté (23A), et sur un quatrième côté (23F), opposé au deuxième côté (23B), les parties des premier et troisième côtés (23A, 23E) étant complémentaires afin de permettre la lecture de chacune des colonnes de pixels de la zone image (23), les blocs (12) d'adressage de lignes étant situés sur une partie d'un cinquième côté (23C), adjacent au deuxième côté (23B), sur un sixième côté (23D), adjacent aux troisième et cinquième côtés (23E, 23C), sur une partie d'un septième côté (23G), opposé au cinquième côté (23C), et sur un huitième côté (23H), opposé au sixième côté (23D), les parties des cinquième et septième côtés (23C, 23G) étant complémentaires afin de permettre l'adressage de chacune des lignes de pixels de la zone image (23).

18. Procédé selon l'une des revendications 1 à 13, dans lequel les blocs (12) d'adressage de lignes sont situés à l'intérieur de la zone image (23).

19. Procédé selon la revendication 18, dans lequel les blocs (12) d'adressage de lignes sont adjacents à l'une des colonnes de pixels comprenant le plus grand nombre de pixels.

20. Procédé selon l'une des revendications 1 à 13, dans lequel les blocs (12) d'adressage de lignes sont situés à la périphérie de la zone image (23), des blocs (12) d'adressage de lignes étant parallèles aux lignes de pixels et des blocs (12) d'adressage de lignes étant inclinés par rapport aux lignes et aux colonnes de pixels, les conducteurs de ligne étant formés sur une première face (couche métallique) du substrat, le capteur (111) comprenant, en outre, des bus de commande formés sur une deuxième face (couche métallique) du substrat et des trous métallisés (62) formés dans la zone image (23), les bus de commande étant orientés parallèlement aux colonnes de pixels et étant reliés aux blocs (12) d'adressage de lignes, les trous métallisés (62) reliant chaque conducteur de ligne (Xᵢ, X_{RAZi}) à l'un des bus de commande.

21. Procédé selon la revendication 11, dans lequel chaque bloc (13) de lecture de colonnes est parallèle aux lignes de pixels, les blocs (12) d'adressage de lignes étant situés à la périphérie de la zone image (23), parallèlement aux lignes de pixels, les conducteurs de ligne étant formés sur une première face (couche métallique) du substrat, le capteur comprenant, en outre, des bus de commande formés sur une deuxième face (couche métallique) du substrat et des trous métallisés (62) formés dans la zone image (23), les bus de commande étant orientés parallèlement aux colonnes de pixels et étant reliés aux blocs (12) d'adressage de lignes, les trous métallisés (62) reliant chaque conducteur de ligne (Xᵢ, X_{RAZi}) à l'un des bus de commande.

22. Procédé selon la revendication 11, dans lequel chaque bloc (13) de lecture de colonnes est parallèle aux lignes de pixels, une partie des blocs (13) de lecture de colonnes étant située à une première extrémité des colonnes de pixels et une autre partie étant située à une deuxième extrémité des colonnes de pixels, les deux parties étant complémentaires afin de permettre la lecture de chacune des colonnes de pixels de la zone image (23), les blocs (12) d'adressage de lignes étant situés à la périphérie de la zone image (23), parallèlement aux colonnes de pixels, une partie des blocs (12) d'adressage de lignes étant située à une première extrémité des lignes de pixels et une autre partie étant située à une deuxième extrémité des lignes de pixels, les deux parties étant complémentaires afin de permettre l'adressage de chacune des lignes de pixels de la zone image (23).

23. Procédé selon la revendication 11, dans lequel les pixels périphériques de la zone image (23) forment sensiblement un hexagone convexe dont un premier côté est parallèle aux lignes de pixels, dont un deuxième et un troisième côté, adjacents au premier côté, sont parallèles aux colonnes de pixels, dont un quatrième et un cinquième côté, respectivement adjacents au deuxième et au troisième côté, sont inclinés par rapport aux lignes et aux colonnes de pixels, et dont un sixième côté, adjacent au quatrième et au cinquième côté, est parallèle aux lignes de pixels.

24. Procédé selon l'une des revendications 1 à 23, dans lequel chaque pixel (24) du capteur comporte un élément photosensible (Dp(i,j)) générant des charges électriques en fonction d'un rayonnement reçu par le dispositif imageur.

25. Procédé selon la revendication 24, dans lequel le capteur comprend, en outre, un scintillateur couplé optiquement au capteur (21, 61, 91, 111, 191, 211) et permettant de convertir un rayonnement X ou gamma en un rayonnement auquel les éléments photosensibles (Dp(i,j)) sont sensibles.

26. Procédé selon l'une des revendications 1 à 25, dans lequel l'élément collecteur de charges de chaque pixel (24) comprend une électrode de collecte de charges électriques.

27. Procédé selon la revendication 26 comprenant, en outre, un photoconducteur couplé électriquement aux électrodes de collecte de charges des pixels (24) du capteur, le photoconducteur permettant de convertir un rayonnement X ou gamma en charges électriques.

28. Procédé selon la revendication 27, dans lequel le photoconducteur est réalisé en tellurure de cadmium (CdTe), en un composé comprenant du tellurure, du cadmium et du zinc (CdₓTe_{y}Zn_{z}), en arséniure de gallium (AsGa), en iodure de mercure (Hgl₂), en oxyde de plomb (PbO), en iodure de plomb (Pbl₂), ou en Sélénium (Se).

29. Procédé selon l'une des revendications 1 à 28, dans lequel chaque bloc (12) d'adressage de lignes et chaque bloc (13) de lecture de colonnes comprend des plots de connexion (121, 131, 921, 922) aptes à relier les conducteurs de ligne (Xᵢ, X_{RAZi}) et les conducteurs de colonnes (Yⱼ) à des circuits externes, lesdits plots de connexion étant alignés dans chaque bloc (12, 13) sur une ou plusieurs rangées.

30. Procédé selon la revendication 29 et l'une des revendications 12 et 13, dans lequel les plots de connexion (121, 131, 921, 922) de chaque bloc (12, 13) sont alignés avec les bords du substrat (22).

## Patentansprüche

1. Verfahren zur fotolithografischen Herstellung einer Bildgebungsvorrichtung auf einer Halbleiterscheibe (22), die ein Substrat bildet, wobei der Sensor Folgendes umfasst:
• eine Bildzone (23), die auf dem Substrat hergestellt ist und eine nach Reihen und Spalten angeordnete Gruppe von Pixeln (24) umfasst, wobei die Anzahl von Pixeln pro Spalte nicht für alle Pixelspalten einheitlich ist, wobei jedes Pixel (24) ein Ladungssammelelement umfasst, das elektrische Ladungen sammelt, die als Funktion einer von der Bildgebungsvorrichtung empfangenen Photonenstrahlung erzeugt werden,
• Reihenleiter (Xᵢ, X_{RAZi}), die die Pixel Reihe für Reihe verbinden,
• Spaltenleiter (Yⱼ), die die Pixel Spalte für Spalte verbinden,
• Reihenadressierblöcke (12), die mit den Reihenleitern (Xᵢ, X_{RAZi}) verbunden sind und eine individuelle Adressierung jeder Pixelreihe zulassen, und
• Spaltenleseblöcke (13), die mit den Spaltenleitern (Yⱼ) verbunden sind und das Lesen der elektrischen Ladungen zulassen, die von den Pixeln (24) der durch die Reihenadressierblöcke (12) gewählten Reihe gesammelt wurden, wobei sich die Spaltenleseblöcke (13) an der Peripherie der Bildzone (23) befinden,
• wobei die Reihenadressierblöcke (12) und die Spaltenleseblöcke (13) auf demselben Substrat (22) hergestellt sind wie die Bildzone;
wobei das Verfahren ferner einen Schritt beinhaltet, in dem eine Oberfläche der Halbleiterscheibe (22) Zone für Zone einer Strahlung durch zwei oder drei Maskensätze ausgesetzt ist; wobei jeder Maskensatz mehrere Masken umfasst: wobei jede Maske eines selben Maskensatzes mehrere Regionen umfasst, wobei jede Region einem bestimmten Motiv entspricht; wobei die zwei oder drei Maskensätze so konfiguriert sind, dass sie unterschiedliche Motive auf der Oberfläche der Halbleiterscheibe (22) fotolithografisch herstellen können; wobei die Bildzone durch aufeinander folgende Herstellung von Motiven nebeneinander auf der Oberfläche der Halbleiterscheibe erhalten wird; wobei die so erhaltene Bildzone (23) eine Oberfläche von gleich oder größer als 10 cm² aufweist;
wobei das Verfahren auch **dadurch gekennzeichnet ist, dass** die Anzahl von implementierten Motiven grundsätzlich größer als 1 und kleiner als 15 ist.

2. Verfahren nach Anspruch 1, bei dem jede Maske der zwei oder drei Maskensätzen n separate Regionen umfasst, die jeweils die fotolithografische Herstellung von n Motiven zulassen, wobei n eine ganze Zahl zwischen 1 und 15 ist.

3. Verfahren nach Anspruch 1 oder 2, bei dem die Anzahl von implementierten Motiven kleiner als 8 ist.

4. Verfahren nach einem der Ansprüche 1 bis 3, bei dem die peripheren Pixel der Bildzone im Wesentlichen ein Polygon mit mindestens 5 Seiten bilden.

5. Verfahren nach einem der Ansprüche 1 bis 4, bei dem die peripheren Pixel der Bildzone im Wesentlichen ein Polygon mit weniger als 20 Seiten bilden.

6. Verfahren nach einem der Ansprüche 1 bis 5, bei dem die peripheren Pixel der Bildzone im Wesentlichen ein regelmäßiges Oktagon bilden.

7. Verfahren nach einem der Ansprüche 1 bis 6, bei dem jeder Reihenadressierblock (12) des Sensors (61) durch Herstellen eines Motivs (711, 712, 724) gebildet wird, das eine Region umfasst, die dem Reihenadressierblock (12) entspricht, wobei mindestens eines der Motive (711, 712) einen Reihenadressierblock bildet, der mit Bezug auf die Pixelreihen und -spalten geneigte Formen aufweist.

8. Verfahren nach einem der Ansprüche 1 bis 7, bei dem jeder Spaltenleseblock (13) des Sensors (21) durch Herstellen eines Motivs (311, 312, 322) gebildet wird, das eine Region umfasst, die dem Block (13) entspricht, wobei mindestens eines der Motive (311, 312) einen Spaltenleseblock bildet, der mit Bezug auf die Pixelreihen und -spalten geneigte Formen aufweist.

9. Verfahren nach einem der Ansprüche 1 bis 8, bei dem die zwei oder drei Maskensätze (31, 32) eine rechteckige Form haben, wobei jedes auf der Halbleiterscheibe (22) herzustellende Motiv durch eine oder mehrere Verschlussklappen gewählt wird.

10. Verfahren nach einem der Ansprüche 1 bis 9, bei dem die Oberfläche der Halbleiterscheibe (22) durch die zwei oder drei Maskensätze (311, 312, 322, 323, 324) exponiert wird, von denen jede Maske eine Region umfasst, die die Bildung einer die Bildzone (23), die Reihenadressierblöcke (12) und die Spaltenleseblöcke (13) umgebende Schnittlinie (25) zulässt; wobei die Schnittlinie (25) das Schneiden der Halbleiterscheibe (22) erleichtert; wobei das Verfahren ferner einen Schritt des Schneidens der Halbleiterscheibe (22) entlang der Schnittlinie (25) zum Bilden des Sensors (21, 61, 91, 111, 191) beinhaltet.

11. Verfahren nach einem der Ansprüche 1 bis 10, bei dem mindestens zwei Spaltenleseblöcke (13) an Pixel (24) angrenzen, die zu Reihen von separaten Ebenen gehören.

12. Verfahren nach einem der Ansprüche 4 oder 5, bei dem die Spaltenleseblöcke (13) in Sets gruppiert sind, wobei jedes Set parallel zu einer der Seiten (23D, 23E, 23F) des Polygons ist.

13. Verfahren nach den Ansprüchen 6 und 12, bei dem sich die Spaltenleseblöcke (13) eines ersten Sets auf einer ersten Seite (23D) des regelmäßigen Oktagons befinden, wobei sich die Spaltenleseblöcke (13) eines zweiten Sets auf einer zweiten Seite (23E) neben der ersten befinden und die Spaltenleseblöcke (13) eines dritten Sets sich auf einer dritten Seite (23F) neben der zweiten Seite befinden.

14. Verfahren nach einem der Ansprüche 1 bis 13, bei dem sich die Reihenadressierblöcke (12) an der Peripherie der Bildzone (23) befinden.

15. Verfahren nach den Ansprüchen 13 und 14, bei dem sich die Reihenadressierblöcke (12) auf Seiten (23A, 23B, 23H) des regelmäßigen Oktagons befinden, die gegenüber der ersten, der zweiten und der dritten Seite (23D, 23E, 23F)liegen, wobei die Reihenleiter auf einer ersten Fläche des Substrats (22) ausgebildet sind, wobei der Sensor (61) ferner auf einer zweiten Fläche (metallische Schicht) des Substrats ausgebildete Steuerbusse und in der Bildzone (23) ausgebildete metallisierte Löcher (62) umfasst, wobei die Steuerbusse parallel zu den Pixelspalten orientiert und mit den Reihenadressierblöcken (12) verbunden sind, wobei die metallisierten Löcher (62) jeden Reihenleiter (Xᵢ, X_{RAZi}) mit einem der Steuerbusse verbinden.

16. Verfahren nach den Ansprüchen 13 und 14, bei dem sich die Reihenadressierblöcke (92) auf denselben Seiten (23D, 23E, 23F) des regelmäßigen Oktagons befinden wie die Spaltenleseblöcke (92), wobei die Reihenleiter auf einer ersten Fläche (metallische Schicht) des Substrats ausgebildet sind, wobei der Sensor (91) ferner auf einer zweiten Fläche (metallische Schicht) des Substrats ausgebildete Steuerbusse und in der Bildzone (23) ausgebildete metallisierte Löcher (62) umfasst, wobei die Steuerbusse parallel zu den Pixelspalten orientiert und mit den Reihenadressierblöcken (92) verbunden sind, wobei die metallisierten Löcher (62) jeden Reihenleiter (Xᵢ, X_{RAZi}) mit einem der Steuerbusse verbinden.

17. Verfahren nach den Ansprüchen 13 und 14, bei dem sich die Spaltenleseblöcke (13) auf einem Teil einer ersten Seite (23A) des regelmäßigen Oktagons, auf einer zweiten Seite (23B) neben der ersten Seite (23A), auf einem Teil einer dritten Seite (23E) gegenüber der ersten Seite (23A) und auf einer vierten Seite (23F) gegenüber der zweiten Seite (23B) befinden, wobei die Teile der ersten und dritten Seite (23A, 23E) komplementär sind, um das Lesen jeder der Pixelspalten der Bildzone (23) zuzulassen, wobei sich die Reihenadressierblöcke (12) auf einem Teil einer fünften Seite (23C) neben der zweiten Seite (23B), auf einer sechsten Seite (23D) neben der dritten und fünften Seite (23E, 23C), auf einem Teil einer siebten Seite (23G) gegenüber der fünften Seite (23C) und auf einer achten Seite (23H) gegenüber der sechsten Seite (23D) befinden, wobei die Teile der fünften und siebten Seite (23C, 23G) komplementär sind, um das Adressieren jeder der Pixelreihen der Bildzone (23) zuzulassen.

18. Verfahren nach einem der Ansprüche 1 bis 13, bei dem sich die Reihenadressierblöcke (12) im Innern der Bildzone (23) befinden.

19. Verfahren nach Anspruch 18, bei dem die Reihenadressierblöcke (12) einer der Pixelspalten benachbart ist, die die größte Anzahl von Pixeln umfasst.

20. Verfahren nach einem der Ansprüche 1 bis 13, bei dem sich die Reihenadressierblöcke (12) an der Peripherie der Bildzone (23) befinden, wobei einige Reihenadressierblöcke (12) parallel zu den Pixelreihen sind und einige Reihenadressierblöcke (12) in Bezug auf die Pixelreihen und -spalten geneigt sind, wobei die Reihenleiter auf einer ersten Fläche (metallische Schicht) des Substrats gebildet sind, wobei der Sensor (111) ferner auf einer zweiten Fläche (metallische Schicht) des Substrats ausgebildete Steuerbusse und in der Bildzone (23) ausgebildete metallisierte Löcher (62) umfasst, wobei die Steuerbusse parallel zu den Pixelspalten orientiert und mit den Reihenadressierblöcken (12) verbunden sind, wobei die metallisierten Löcher (62) jeden Reihenleiter (Xᵢ, X_{RAZi}) mit einem der Steuerbusse verbinden.

21. Verfahren nach Anspruch 11, bei dem jeder Spaltenleseblock (13) parallel zu den Pixelreihen ist, wobei sich die Reihenadressierblöcke (12) an der Peripherie der Bildzone (23) parallel zu den Pixelreihen befinden, wobei sich die Reihenleiter auf einer ersten Fläche (metallische Schicht) des Substrats befinden, wobei der Sensor ferner auf einer zweiten Fläche (metallische Schicht) des Substrats ausgebildete Steuerbusse und in der Bildzone (23) ausgebildete metallisierte Löcher (62) umfasst, wobei die Steuerbusse parallel zu den Pixelspalten orientiert und mit den Reihenadressierblöcken (12) verbunden sind, wobei die metallisierten Löcher (62) jeden Reihenleiter (Xᵢ, X_{RAZi}) mit einem der Steuerbusse verbinden.

22. Verfahren nach Anspruch 11, bei dem jeder Spaltenleseblock (13) parallel zu den Pixelreihen ist, wobei sich ein Teil der Spaltenleseblöcke (13) an einem ersten Ende der Pixelspalten befindet und sich ein anderer Teil an einem zweiten Ende der Pixelspalten befindet, wobei die beiden Teile komplementär sind, um das Lesen jeder Pixelspalte der Bildzone (23) zuzulassen, wobei sich die Reihenadressierblöcke (12) an der Peripherie der Bildzone (23) parallel zu den Pixelspalten befinden, wobei sich ein Teil der Reihenadressierblöcke (12) an einem ersten Ende der Pixelreihen befindet und ein anderer Teil sich an einem zweiten Ende der Pixelreihen befindet, wobei die beiden Teile komplementär sind, um das Adressieren jeder der Pixelreihen der Bildzone (23) zuzulassen.

23. Verfahren nach Anspruch 11, bei dem die peripheren Pixel der Bildzone (23) im Wesentlichen ein konvexes Hexagon bilden, von dem eine erste Seite parallel zu den Pixelreihen ist, von dem eine zweite und eine dritte Seite neben der ersten Seite parallel zu den Pixelspalten sind, von dem eine vierte und eine fünfte Seite jeweils neben der zweiten bzw. der dritten Seite in Bezug auf die Pixelreihen und -spalten geneigt sind, und von dem eine sechste Seite neben der vierten und der fünften Seite parallel zu den Pixellinien ist.

24. Verfahren nach einem der Ansprüche 1 bis 23, bei dem jedes Pixel (24) des Sensors ein fotoempfindliches Element (Dp(i,j)) umfasst, das elektrische Ladungen als Funktion einer von der Bildgebungsvorrichtung empfangenen Strahlung erzeugt.

25. Verfahren nach Anspruch 24, bei dem der Sensor ferner einen Szintillator umfasst, der optisch mit dem Sensor (21, 61, 91, 111, 191, 211) gekoppelt ist und das Umwandeln einer Röntgen- oder Gammastrahlung in eine Strahlung zulässt, für die die fotoempfindlichen Elemente (Dp(i,j)) empfindlich sind.

26. Verfahren nach einem der Ansprüche 1 bis 25, bei dem das Ladungssammelelement jedes Pixels (24) eine Elektrode zum Sammeln von elektrischen Ladungen umfasst.

27. Verfahren nach Anspruch 26, das ferner einen Fotoleiter umfasst, der elektrisch mit den Ladungssammelelektroden von Pixeln (24) des Sensors gekoppelt ist, wobei der Fotoleiter das Umwandeln einer Röntgen- oder Gammastrahlung in elektrische Ladungen zulässt.

28. Verfahren nach Anspruch 27, bei dem der Fotoleiter aus Cadmiumtellurid (CdTe), aus einer Tellurid, Cadmium und Zink (CdₓTe_{y}Zn_{z}) umfassenden Verbindung, aus Galliumarsenid (AsGa), aus Quecksilberiodid (HgI₂), aus Bleioxid (PbO), aus Bleiiodid (PbI₂) oder aus Selen (Se) hergestellt ist.

29. Verfahren nach einem der Ansprüche 1 bis 28, bei dem jeder Reihenadressierblock (12) und jeder Spaltenleseblock (13) Anschlusspads (121, 131, 921, 922) umfasst, die die Reihenleiter (Xᵢ, X_{RAZi}) und die Spaltenleiter (Yⱼ) mit externen Schaltungen verbinden können, wobei die Anschlusspads in jedem Block (12, 13) auf einer oder mehreren Ebenen ausgerichtet sind.

30. Verfahren nach Anspruch 29 und einem der Ansprüche 12 und 13, bei dem die Anschlusspads (121, 131, 921, 922) jedes Blocks (12, 13) mit den Rändern des Substrats (22) ausgerichtet sind.

## Claims

1. A method for producing by photolithography an imaging device on a semi-conducting wafer (22) forming a substrate; the sensor comprising:
• an image zone (23) produced on the substrate and comprising a group of pixels (24) disposed in rows and columns, the number of pixels per column not being uniform for all the columns of pixels, each pixel (24) comprising a charge collector element collecting electric charges generated as a function of a photon radiation received by the imaging device,
• row conductors (Xᵢ, X_{RAZi}) linking the pixels row by row,
• column conductors (Yⱼ) linking the pixels column by column,
• row addressing blocks (12) linked to the row conductors (Xᵢ, X_{RAZi}) and making it possible to address each row of pixels individually, and
• column reading blocks (13) linked to the column conductors (Yⱼ) and making it possible to read the electric charges collected by the pixels (24) of the row selected by the row addressing blocks (12), the column reading blocks (13) being situated at the periphery of the image zone (23),
• the row addressing blocks (12) and the column reading blocks (13) being produced on the same substrate (22) as the image zone;
the method further comprising a step in which a surface of the semi-conducting wafer (22) is exposed zone by zone to a radiation through two or three sets of masks; each set of masks comprising several masks; each mask of one and the same set of masks including several regions, each region corresponding to a particular pattern; the at least two or three mask sets being configured to be able to produce, by photolithography, various patterns on the surface of the semi-conducting wafer (22); the image zone being obtained by the successive production of patterns, adjacent to one another, on the surface of the semi-conducting wafer; the image zone (23) thus obtained exhibiting a surface area of greater than or equal to 10 cm²;
the method being also **characterized in that** the number of patterns implemented is strictly greater than 1 and less than 15.

2. The method according to claim 1, in which each mask of the two or three sets of masks comprises n distinct regions, allowing respectively the production, by photolithography, of n patterns; n being an integer lying between 1 and 15.

3. The method according to one of claim 1 or 2, in which the number of patterns implemented is less than 8.

4. The method according to one of claims 1 to 3, in which the peripheral pixels of the image zone form substantially a polygon comprising at least 5 sides.

5. The method according to one of claims 1 to 4, in which the peripheral pixels of the image zone form substantially a polygon comprising a number of sides less than 20.

6. The method according to one of claims 1 to 5, in which the peripheral pixels of the image zone form substantially a regular octagon.

7. The method according to one of claims 1 to 6, in which each row addressing block (12) of the sensor (61) is formed by the production of a pattern (711, 712, 724) comprising a region corresponding to said row addressing block (12), at least one of the patterns (711, 712) forming a row addressing block exhibiting shapes inclined with respect to the rows and to the columns of pixels.

8. The method according to one of claims 1 to 7, in which each column reading block (13) of the sensor (21) is formed by the production of a pattern (311, 312, 322) comprising a region corresponding to said block (13), at least one of the patterns (311, 312) forming a column reading block exhibiting shapes inclined with respect to the rows and to the columns of pixels.

9. The method according to one of claims 1 to 8, in which the two or three sets of masks (31, 32) are of rectangular shape, each pattern to be produced on the semi-conducting wafer (22) being selected by one or more obturation flaps.

10. The method according to one of claims 1 to 9, in which the surface of the semi-conducting wafer (22) is exposed through the two or three sets of masks (311, 312, 322, 323, 324), each mask of which comprises a region making it possible to form a cutting line (25) surrounding the image zone (23), the row addressing blocks (12) and the column reading blocks (13); the cutting line (25) facilitating the cutting of the semi-conducting wafer (22); the method comprising, furthermore, a step of cutting the semi-conducting wafer (22) along the cutting line (25) to form the sensor (21, 61, 91, 111, 191).

11. The method according to one of claims 1 to 10, in which at least two column reading blocks (13) are contiguous with pixels (24) belonging to rows of distinct ranks.

12. The method according to one of claims 4 or 5, in which the column reading blocks (13) are clustered together in groups, each group being parallel to one of the sides (23D, 23E, 23F) of the polygon.

13. The method according to claims 6 and 12, in which the column reading blocks (13) of a first group are situated on a first side (23D) of the regular octagon, the column reading blocks (13) of a second group are situated on a second side (23E) adjacent to the first, and the column reading blocks (13) of a third group are situated on a third side (23F) adjacent to the second side.

14. The method according to one of claims 1 to 13, in which the row addressing blocks (12) are situated at the periphery of the image zone (23).

15. The method according to claims 13 and 14, in which the row addressing blocks (12) are situated on sides (23A, 23B, 23H) of the regular octagon that are opposite the first, the second and the third side (23D, 23E, 23F), the row conductors being formed on a first face of the substrate (22), the sensor (61) comprising, furthermore, control buses formed on a second face (metallic layer) of the substrate and metallized holes (62) formed in the image zone (23), the control buses being oriented parallel to the columns of pixels and being linked to the row addressing blocks (12), the metallized holes (62) linking each row conductor (Xᵢ, X_{RAZi}) to one of the control buses.

16. The method according to claims 13 and 14, in which the row addressing blocks (92) are situated on the same sides (23D, 23E, 23F) of the regular octagon as the column reading blocks (92), the row conductors being formed on a first face (metallic layer) of the substrate, the sensor (91) comprising, furthermore, control buses formed on a second face (metallic layer) of the substrate and metallized holes (62) formed in the image zone (23), the control buses being oriented parallel to the columns of pixels and being linked to the row addressing blocks (92), the metallized holes (62) linking each row conductor (Xᵢ, X_{RAZi}) to one of the control buses.

17. The method according to claims 13 and 14, in which the column reading blocks (13) are situated on a part of a first side (23A) of the regular octagon, on a second side (23B) adjacent to the first side (23A), on a part of a third side (23E) opposite the first side (23A), and on a fourth side (23F) opposite the second side (23B), the parts of the first and third sides (23A, 23E) being complementary so as to allow the reading of each of the columns of pixels of the image zone (23), the row addressing blocks (12) being situated on a part of a fifth side (23C) adjacent to the second side (23B), on a sixth side (23D) adjacent to the third and fifth sides (23E, 23C), on a part of a seventh side (23G) opposite the fifth side (23C), and on an eighth side (23H) opposite the sixth side (23D), the parts of the fifth and seventh sides (23C, 23G) being complementary so as to allow the addressing of each of the rows of pixels of the image zone (23).

18. The method according to one of claims 1 to 13, in which the row addressing blocks (12) are situated inside the image zone (23).

19. The method according to claim 18, in which the row addressing blocks (12) are adjacent to one of the columns of pixels comprising the largest number of pixels.

20. The method according to one of claims 1 to 13, in which the row addressing blocks (12) are situated at the periphery of the image zone (23), some row addressing blocks (12) being parallel to the rows of pixels and some row addressing blocks (12) being inclined with respect to the rows and to the columns of pixels, the row conductors being formed on a first face (metallic layer) of the substrate, the sensor (111) comprising, furthermore, control buses formed on a second face (metallic layer) of the substrate and metallized holes (62) formed in the image zone (23), the control buses being oriented parallel to the columns of pixels and being linked to the row addressing blocks (12), the metallized holes (62) linking each row conductor (Xᵢ, X_{RAZi}) to one of the control buses.

21. The method according to claim 11, in which each column reading block (13) is parallel to the rows of pixels, the row addressing blocks (12) being situated at the periphery of the image zone (23), parallel to the rows of pixels, the row conductors being formed on a first face (metallic layer) of the substrate, the sensor comprising, furthermore, control buses formed on a second face (metallic layer) of the substrate and metallized holes (62) formed in the image zone (23), the control buses being oriented parallel to the columns of pixels and being linked to the row addressing blocks (12), the metallized holes (62) linking each row conductor (Xᵢ, X_{RAZi}) to one of the control buses.

22. The method according to claim 11, in which each column reading block (13) is parallel to the rows of pixels, a part of the column reading blocks (13) being situated at a first end of the columns of pixels and another part being situated at a second end of the columns of pixels, the two parts being complementary so as to allow the reading of each of the columns of pixels of the image zone (23), the row addressing blocks (12) being situated at the periphery of the image zone (23), parallel to the columns of pixels, a part of the row addressing blocks (12) being situated at a first end of the rows of pixels and another part being situated at a second end of the rows of pixels, the two parts being complementary so as to allow the addressing of each of the rows of pixels of the image zone (23).

23. The method according to claim 11, in which the peripheral pixels of the image zone (23) form substantially a convex hexagon a first side of which is parallel to the rows of pixels, a second and a third side of which, both adjacent to the first side, are parallel to the columns of pixels, a fourth and a fifth side of which, respectively adjacent to the second and to the third side, are inclined with respect to the rows and to the columns of pixels, and a sixth side of which, adjacent to the fourth and to the fifth side, is parallel to the rows of pixels.

24. The method according to one of claims 1 to 23, in which each pixel (24) of the sensor comprises a photosensitive element (Dp(i,j)) generating electric charges as a function of a radiation received by the imaging device.

25. The method according to claim 24 comprising, furthermore, a scintillator coupled optically to the sensor (21, 61, 91, 111, 191, 211) and making it possible to convert an X-ray or gamma-ray radiation into a radiation to which the photosensitive elements (Dp(i,j)) are sensitive.

26. The method according to one of claim 1 to 25, in which the charge collector element of each pixel (24) comprises an electrode for collecting electric charges.

27. The method according to claim 26 comprising, furthermore, a photoconductor coupled electrically to the electrodes for collecting charges of the pixels (24) of the sensor, the photoconductor making it possible to convert an X-ray or gamma-ray radiation into electric charges.

28. The method according to claim 27, in which the photoconductor is made of cadmium telluride (CdTe), of a compound comprising telluride, cadmium and zinc (CdₓTe_{y}Zn_{z}), of gallium arsenide (AsGa), of mercury iodide (HgI₂), of lead oxide (PbO), of lead iodide (PbI₂), or of Selenium (Se).

29. The method according to one of claim 1 to 28, in which each row addressing block (12) and each column reading block (13) comprises connection pads (121, 131, 921, 922) able to link the row conductors (Xᵢ, X_{RAZi}) and the conductors of columns (Yⱼ) to external circuits, said connection pads being aligned in each block (12, 13) in one or more lines.

30. The method according to claim 29 and one of claims 12 and 13, in which the connection pads (121, 131, 921, 922) of each block (12, 13) are aligned with the edges of the substrate (22).
